# EUROPEAN PATENT APPLICATION

(11) **EP 4 580 362 A1**
(43) Date of publication of application: **02.07.2025**
(21) Application number: 24197915.2
(22) Date of filing: 02.09.2024
(51) Int. Cl.: H10K 59/121, H10K 59/131, H10K 59/35, H10K 71/00, H10K 59/38, H10K 59/80

(54) **TRANSPARENT DISPLAY APPARATUS**

(30) Priority: 28.12.2023 KR 20230195029
(71) Applicant: LG Display Co., Ltd., Seoul 07336 (KR)
(72) Inventor: KIM, Binn, 10845 Gyeonggi-do (KR)
(74) Representative: Viering, Jentschura & Partner mbB Patent- und Rechtsanwälte

(57) **Abstract**

A transparent display apparatus includes a first pixel (P1) disposed on a substrate (110) and having a plurality of first sub-pixels (SP1) and a plurality of transmissive portions (TA), a second pixel (P2) disposed adjacent to the first pixel (P1) and having a plurality of second sub-pixels (SP2) and a plurality of transmissive portions (TA), and a third pixel (P3) disposed adjacent to the first pixel (P1) and the second pixel (P2) and having a plurality of third sub-pixels (SP3) and a plurality of transmissive portions (TA), wherein one first sub-pixel of the plurality of first sub-pixels (SP1) one second sub-pixel of the plurality of second sub-pixels (SP2), and one third sub-pixel of the plurality of third sub-pixels (SP3) are disposed adjacent to each other. The present disclosure can improve the transmissivity of a transmissive portion, minimize the perceptibility of a sub-pixel in which a dark point has occurred, reduce overall power consumption, and prevent reduced visibility due to diffraction phenomenon.

## Description

### CROSS-REFERENCE TO RELATED APPLICATION

This application claims the priority of the Korean Patent Applications No. 10-2023-0195029 filed on December 28, 2023.

### BACKGROUND

### Field of the Disclosure

The present disclosure relates to a transparent display apparatus.

### Description of the Background

With the advancement of the information age, the demand for a display device for displaying an image has increased in various forms. Therefore, various types of display devices such as a liquid crystal display (LCD) device, a plasma display panel (PDP) device, a quantum dot light emitting display (QLED) device, and an organic light emitting display (OLED) device have been recently used.

Recently, studies for a transparent display apparatus in which a user may view objects or image positioned at an opposite side by transmitting the display apparatus are actively ongoing.

The transparent display apparatus may include a display area on which an image is displayed and a non-display area, and the display area may include a transmissive area capable of transmitting external light and a light emission area. he transparent display apparatus may have a high light transmittance in the display area through the transmissive area.

On the other hand, in the transparent display apparatus, one sub-pixel is divided into a plurality of sub-pixels in the display area, and the plurality of divided sub-pixels are connected to thin-film transistors through repair wiring. Also, when a dark point occurs in any one of the plurality of divided sub-pixels, the repair wiring connected to the sub-pixel in which the dark point occurs may be cut so that the remaining sub-pixels may be operated normally. Here, the transparent display apparatus has a problem that the repair wiring connecting the plurality of divided sub-pixels is disposed in the transmissive area, thus the transmissivity of the transmissive area is reduced.

### SUMMARY

Accordingly, the present disclosure is directed to a transparent display apparatus that substantially obviates one or more of problems due to limitations and disadvantages described above.

More specifically, the present disclosure is to provide a transparent display apparatus capable of improving the transmissivity of a transmissive portion.

The present disclosure is also to provide a transparent display apparatus that may minimize the perceptibility of a sub-pixel in which a dark point has occurred.

The present disclosure is also to provide a transparent display apparatus in which overall power consumption may be reduced.

Further, the present disclosure is to provide a transparent display apparatus in which reduced visibility due to diffraction phenomenon may be prevented.

The problems to be solved by the examples of the present disclosure are not limited to those mentioned above, and other problems not mentioned will be apparent to one of ordinary skill in the art to which the technical spirits of the present disclosure belong from the following description.

Additional features and advantages of the disclosure will be set forth in the description which follows and in part will be apparent from the description, or may be learned by practice of the disclosure. Other advantages of the present disclosure will be realized and attained by the structure particularly pointed out in the written description and claims hereof as well as the appended drawings.

To achieve these and other advantages and in accordance with the present disclosure, as embodied and broadly described, a transparent display apparatus according to claim 1 is provided. Further embodiments are described in the dependent claims. According to an aspect of the present disclosure, a transparent display apparatus includes a first pixel disposed on a substrate and having a plurality of first sub-pixels and a plurality of transmissive portions, a second pixel adj acent to the first pixel and having a plurality of second sub-pixels and a plurality of transmissive portions, and a third pixel adjacent to the first pixel and the second pixel and having a plurality of third sub-pixels and a plurality of transmissive portions, wherein one first sub-pixel of the plurality of first sub-pixels, one second sub-pixel of the plurality of second sub-pixels, and one third sub-pixel of the plurality of third sub-pixels are disposed adjacent to each other.

According to another aspect of the present disclosure, a transparent display apparatus includes a plurality of pixels disposed on a substrate, each of the plurality pixels including a plurality of sub-pixels and a plurality of transmissive portions; and a wiring for driving the plurality of sub-pixels, wherein the plurality of sub-pixels includes two sub-pixels disposed in a first direction and two sub-pixels disposed in a second direction, so that the plurality of sub-pixels is disposed in an X shape in each pixel, wherein the transmissive portions are disposed between every two sub-pixels of the plurality of sub-pixels, and wherein the wiring partially overlaps the plurality of sub-pixels without overlapping the transmissive portions.

### BRIEF DESCRIPTION OF THE DRAWINGS

The accompanying drawings, which are included to provide a further understanding of the disclosure and are incorporated in and constitute a part of this application, illustrate aspects of the disclosure and together with the description serve to explain the principle of the disclosure.

In the drawings:
FIG. 1 is a plan view schematically illustrating a transparent display apparatus according to one aspect of the present disclosure;
FIG. 2 is an enlarged view of A portion in FIG. 1;
FIG. 3 is a diagram illustrating an example arrangement of a plurality of signal lines and a plurality of transistors;
FIG. 4 is a cross-sectional view illustrating one example of I-I' of FIG. 3;
FIG. 5 is a schematic diagram illustrating an operational state according to the example of FIG. 2;
FIG. 6 is a schematic diagram illustrating an operational state according to another example of FIG. 2; and
FIG. 7 is a plan view schematically illustrating a portion of a display area of a transparent display apparatus according to one aspect of the present disclosure.

### DETAILED DESCRIPTION

Reference will now be made in detail to the aspects of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following aspects described with reference to the accompanying drawings. The present disclosure may, however, be embodied in different forms and should not be construed as limited to the aspects set forth herein.

Rather, these aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing aspects of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

"X-axis direction", "Y-axis direction" and "Z-axis direction" should not be construed by a geometric relation only of a mutual vertical relation and may have broader directionality within the range that elements of the present disclosure may act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various aspects of the present disclosure may be partially or overall coupled to or combined with each other and may be variously inter-operated with each other and driven technically as those skilled in the art may sufficiently understand. The aspects of the present disclosure may be carried out independently from each other or may be carried out together in co-dependent relationship.

Hereinafter, the preferred aspects of the present disclosure will be described in detail with reference to the accompanying drawings.

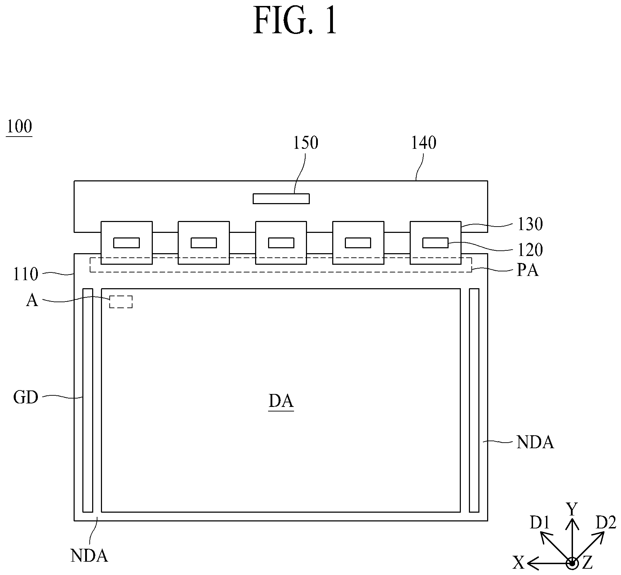

FIG. 1 is a plan view schematically illustrating a transparent display apparatus according to one aspect of the present disclosure.

In the following, the X-axis represents a horizontal direction (i.e., a length direction) of the transparent display apparatus with respect to FIG. 1, the Y-axis represents a perpendicular direction (i.e., a width direction) of the transparent display apparatus with respect to FIG. 1, the first direction D1 represents a first diagonal direction (i.e., a first diagonal direction of a pixel) intersecting the X-axis and Y-axis, the second direction D2 represents a second diagonal direction (a diagonal direction of a pixel) orthogonal to the first diagonal direction, and the Z-axis represents a thickness (or height) direction of the transparent display apparatus 100.

The transparent display apparatus 100 according to one aspect of the present disclosure has been described as an organic light emitting display, but the transparent display apparatus 100 may also be implemented as a liquid crystal display, a plasma display panel (PDP), a quantum dot light emitting display (QLED), or an electrophoresis display.

Referring to FIG. 1, a transparent display apparatus 100 according to one aspect of the present disclosure may include a transparent display panel, a source drive integrated circuit (hereinafter IC) 120, a flexible film 130, a circuit boards 140, and a timing controller 150.

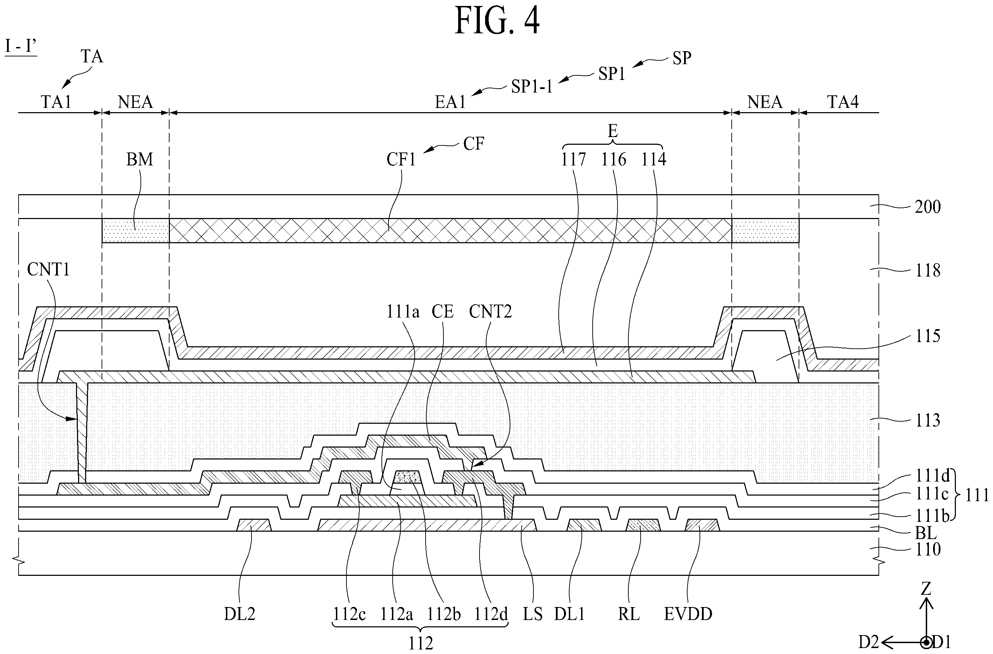

The transparent display panel includes a substrate 110 and an opposing substrate 200 (shown in FIG. 4), that face each other. The substrate 110 may be a plastic film, a glass substrate, or a silicon wafer substrate formed using a semiconductor process. The opposing substrate 200 may be a plastic film, a glass substrate, or an encapsulation film. Such substrate 110 and opposing substrate 200 may be made of a transparent material. The substrate 110 may include a display area DA and a non-display area NDA.

The display area DA is an area where an image is displayed, and may be a pixel array area, an active area, a pixel array unit, a display unit, or a screen. For example, the display area DA may be disposed at a central portion of the display panel. The display area DA may include a plurality of pixels P.

The non-display area NDA may be an area where an image is not displayed, and may be a peripheral area, a signal supply area, a non-active area, or a bezel area. The non-display area NDA may be configured to be around the display area DA. That is, the non-display area NDA may be disposed to surround the display area DA.

A pad portion PA may be disposed in the non-display area NDA. The pad portion PA may supply power and/or signals for outputting images to the pixels P provided in the display area DA. Referring to FIG. 1, the pad portion PA may be provided on the upper side of the display area DA.

Also, Pads, such as power pads, data pads, may be formed in the non-display area of the substrate 110. Lines connecting the pads with the source drive IC 120 and lines connecting the pads with lines of the circuit board 140 may be formed in the flexible film 130. The flexible film 130 may be attached onto the pads by using an anisotropic conducting film, whereby the pads may be connected with the lines of the flexible film 130.

A gate driver GD may be formed in a Gate driver In Panel (GIP) manner on the non-display area NDA outside one or both sides of the display area DA of the substrate 110. Alternatively, the gate driver may be fabricated as a drive chip, mounted on a flexible film, and attached to the non-display area NDA on one side or both sides outside of the display area DA of the substrate 110 in a Tape Automated Bonding (TAB) manner.

The source drive IC 120 receives digital video data and a source control signal from the timing controller 150. The source drive IC 120 converts the digital video data into analog data voltages in accordance with the source control signal and supplies the analog data voltages to the data lines. When the source drive IC 120 is manufactured as a driving chip, the source drive IC 120 may be packaged in the flexible film 130 in a chip on film (COF) method or a chip on plastic (COP) method.

The circuit board 140 may be attached to the flexible films 130. A plurality of circuits implemented as driving chips may be packaged in the circuit board 140. For example, the timing controller 150 may be packaged in the circuit board 140. The circuit board 140 may be a printed circuit board or a flexible printed circuit board.

The timing controller 150 receives the digital video data and a timing signal from an external system board through a cable of the circuit board 140. The timing controller 150 generates a gate control signal for controlling an operation timing of the gate driver GD and a source control signal for controlling the source drive ICs 120 based on the timing signal. The timing controller 150 supplies the gate control signal to the gate driver GD, and supplies the source control signal to the source drive ICs 120.

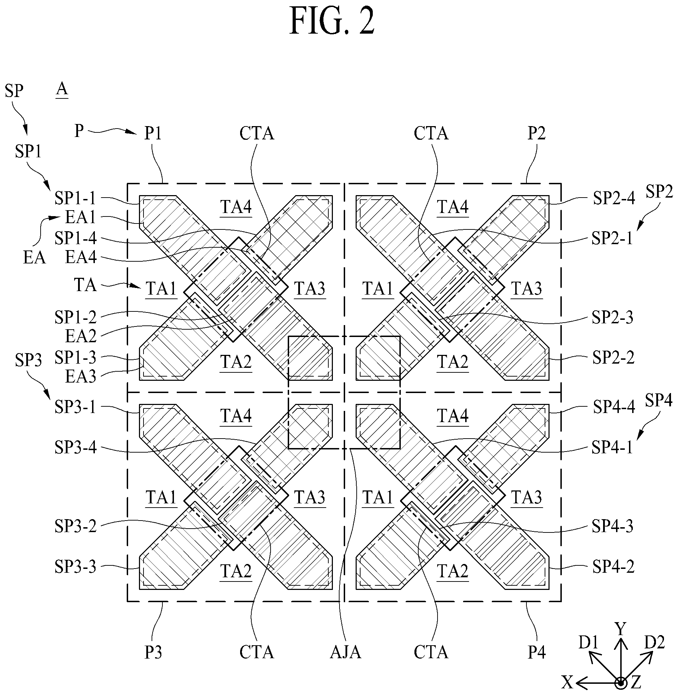

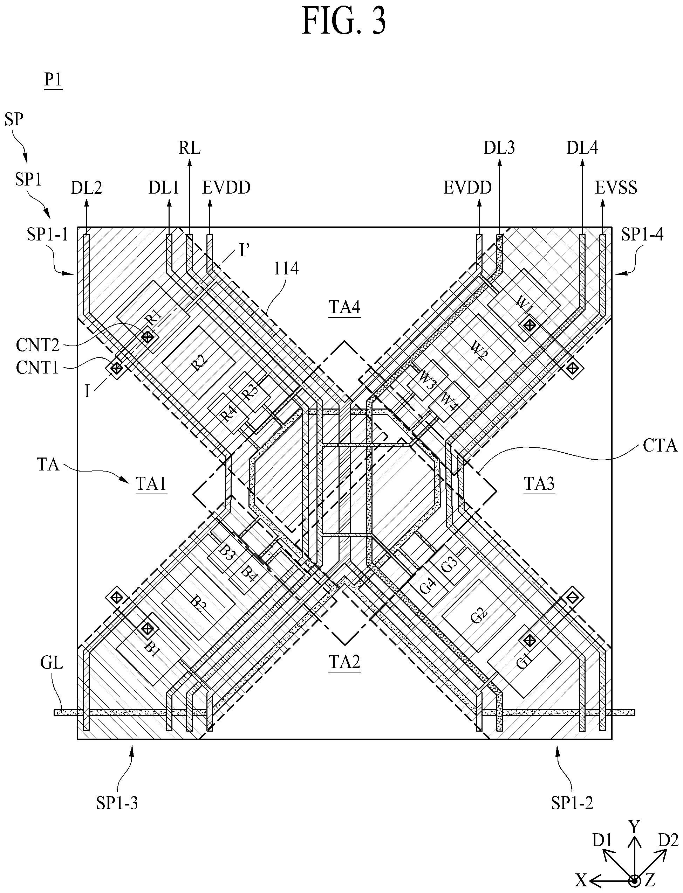

FIG. 2 is an enlarged view of A portion in FIG. 1, FIG. 3 is a diagram illustrating an example arrangement of a plurality of signal lines and a plurality of transistors, and FIG. 4 is a cross-sectional view illustrating one example of I-I' of FIG. 3.

Referring to FIGS. 2 to 4, the substrate 110 according to an example may include the light emission area EA and the non-light emission area NEA.

The light emission area EA may mean an area from which light is emitted. A light emitting element layer E, which includes a pixel electrode 114, an organic light emitting layer 116 and an opposing electrode 117, may be disposed in the light emission area EA. When an electric field is formed between the pixel electrode 114 and the opposing electrode 117, the organic light emitting layer 116 in the light emission area EA may be emitted.

The non-light emission area NEA is an area from which light is not emitted, which may be an area adjacent to the light emission area EA. The non-light emission area NEA may be expressed in terms of the surrounding area.

Referring to FIGS. 2 and 3, a plurality of pixels P according to one example may include a gate line GL, data lines DL1, DL2, DL3, DL4, a pixel power line EVDD, a common power line EVSS, and a reference line RL. Each of the plurality of pixels P may include a plurality of sub-pixels SP that may be defined by the gate lines and data lines.

At least four subpixels, which are provided to emit different colors and disposed to be adjacent to one another, among the plurality of subpixels SP may constitute one pixel P (or unit pixel). One pixel P may include, but is not limited to, a red subpixel, a green subpixel, a blue subpixel and a white subpixel. One pixel P may include three subpixels SP provided to emit light of different colors and disposed to be adjacent to one another. For example, one pixel P may include a red subpixel, a green subpixel and a blue subpixel.

Each of the plurality of subpixels SP includes a thin film transistor and a light emitting element layer E connected to the thin film transistor. Each of the plurality of subpixels may include a light emitting layer (or an organic light emitting layer) interposed between the pixel electrode and the opposing electrode.

The light emitting layers disposed in each of the plurality of sub-pixels SP may emit white light in common. Since the light emitting layer of each of the plurality of sub-pixels SP emits white light in common, each of the red sub-pixel, the green sub-pixel, and the blue sub-pixel may include a color filter CF (or wavelength conversion member CF) that converts the white light to the respective colored light. In this case, the white sub-pixel may not comprise a color filter.

In the display apparatus 100 according to one aspect of the present disclosure, the area with the red color filter may be a red sub-pixel or a first sub-pixel, the area without the color filter may be a white sub-pixel or a second sub-pixel, the area with the blue color filter may be a blue sub-pixel or a third sub-pixel, and the area with the green color filter may be a green sub-pixel or a fourth sub-pixel.

Each of the subpixels SP supplies a predetermined current to the organic light emitting element in accordance with a data voltage of the data line when a gate signal is input from the gate line by using the thin film transistor. For this reason, the light emitting layer of each of the subpixels may emit light with a predetermined brightness in accordance with the predetermined current.

In the transparent display apparatus 100 according to one aspect of the present disclosure, the pixels P may include a first pixel P1, a second pixel P2, and a third pixel P3. The first pixel P1 according to one example is disposed on the substrate 110 and may include a plurality of first sub-pixels SP1 and a plurality of transmissive portions TA. The second pixel P2 according to one example is disposed adjacent to the first pixel P1 and may include a plurality of second sub-pixels SP2 and the plurality of transmissive portions TA. The third pixel P3 according to an example is disposed adjacent to the first pixel P1 and the second pixel P2 and may include a plurality of third sub-pixels SP3 and the plurality of transmissive portions TA.

Here, one first sub-pixel SP1 of the plurality of first sub-pixels SP1 may be disposed adjacent to one second sub-pixel SP2 of the plurality of second sub-pixels SP2, and one third sub-pixel SP3 of the plurality of third sub-pixels SP3, respectively. Any two sub-pixels among the one first sub-pixel SP1, the one second sub-pixel SP2 and the one third sub-pixel SP3 may be disposed adjacent to each other.

For example, as shown in FIG. 2, a first green sub-pixel SP1-2 included in the plurality of first sub-pixels SP1 may be disposed adjacent to a second blue sub-pixel SP2-3 included in the plurality of second sub-pixels SP2, and a third white sub-pixel SP3-4 included in a plurality of third sub-pixels SP3.

Thus, the transparent display apparatus 100 according to one aspect of the present disclosure may have a structural feature in which three sub-pixels SP included respectively in the three pixels P1, P2, and P3 are disposed adjacent to each other, and each of the three adjacent sub-pixels SP is a sub-pixel from which a different color of light is emitted.

The reason why one second sub-pixel SP2 included in the second pixel P2, and one third sub-pixel SP3 included in the third pixel P3 are disposed adjacent to one first sub-pixel SP1 included in the first pixel P1 is that when a dark point occurs in one first sub-pixel SP1 included in the first pixel P1, one second sub-pixel SP2 included in the second pixel P2 and one third sub-pixel SP3 included in the third pixel P3 are emitting light to prevent that the user recognizes the first sub-pixel SP1 in which the dark point has occurred. In other words, the more shared sub-pixels there are, the less visible the dark point is. Here, one first sub-pixel SP1 included in the first pixel P1, one second sub-pixel SP2 included in the second pixel P2, and one third sub-pixel SP3 included in the third pixel P3 may all be sub-pixels that emit the same color.

Also, three sub-pixels SPs emitting different colors of light are disposed adjacent to each other. This is because the other two sub-pixels SPs emit the same color of light as the color of light emitted by the sub-pixel where the dark point occurred is disposed as close as possible to the sub-pixel where the dark point occurred, compared to the other sub-pixels emitting different colors of light. Therefore, the other two sub-pixels emits the same color of light at as close as possible to the sub-pixel where the dark point occurred, thus the user's perception of the dark point may be minimized.

As a result, the transparent display apparatus 100 according to one aspect of the present disclosure may have a feature that one first sub-pixel SP1 (e. g., a first green sub-pixel SP1-2), one second sub-pixel SP2 (e. g., a second blue sub-pixel SP2-3), and one third sub-pixel SP3 (e. g., a third white sub-pixel SP3-4), which are disposed adjacent to each other, emit a different color of light from each other.

Referring again to FIG. 2, the plurality of first sub-pixels SP1 includes a first red sub-pixel SP1-1, a first green sub-pixel SP1-2, a first blue sub-pixel SP1-3, and a first white sub-pixel SP1-4. The first red sub-pixel SP1-1 is disposed in the first direction D1. The first green sub-pixel SP1-2 is disposed adjacent to the first red sub-pixel SP1-1 and disposed in the first direction D1. The first blue sub-pixel SP1-3 is disposed partially adjacent to each of one side of the first red sub-pixel SP1-1 and one side of the first green sub-pixel SP1-2 and disposed in the second direction D2. The first white sub-pixel SP1-4 is disposed partially adjacent to each of the other side of the first red sub-pixel SP1-1 and the other side of the first green sub-pixel SP1-2 and disposed in the second direction D2. The one side of the first red sub-pixel SP1-1 may refer to a left lower side of the first red sub-pixel SP1-1 with respect to FIG. 2. The other side of the first red sub-pixel SP1-1 may refer to a right upper side of the first red sub-pixel SP1-1 with respect to FIG. 2. Thus, in the transparent display apparatus 100 according to one aspect of the present disclosure, the first red sub-pixel SP1-1, the first green sub-pixel SP1-2, the first blue sub-pixel SP1-3, and the first white sub-pixel SP1-4 may be disposed in a windmill shape or an X shape.

The plurality of second sub-pixels SP2 includes a second red sub-pixel SP2-1, a second green sub-pixel SP2-2, a second blue sub-pixel SP2-3, and a second white sub-pixel SP2-4. The second red sub-pixel SP2-1 is disposed in the first direction D1. The second green sub-pixel SP2-2 is disposed adjacent to the second red sub-pixel SP2-1 and disposed in the first direction D1. The second blue sub-pixel SP2-3 is disposed partially adjacent to each of one side of the second red sub-pixel SP2-1 and one side of the second green sub-pixel SP2-2, and disposed in a second direction D2. The second white sub-pixel SP2-4 is disposed partially adjacent to each of the other side of the second red sub-pixel SP2-1 and the other side of the second green sub-pixel SP2-2 and disposed in the second direction D2. One side of the second red sub-pixel SP1-1 may refer to a left lower side of the second red sub-pixel SP2-1 with respect to FIG. 2. The other side of the second red sub-pixel SP2-1 may refer a right upper side of the second red sub-pixel SP2-1 with respect to FIG. 2. Thus, in the transparent display apparatus 100 according to one aspect of the present disclosure, the second red sub-pixel SP2-1, the second green sub-pixel SP2-2, the second blue sub-pixel SP2-3, and the second white sub-pixel SP2-4 may be disposed in a windmill shape or an X shape.

Further, as shown in FIG. 2, each of the plurality of first sub-pixels SP1 and the plurality of second sub-pixels SP2 may be disposed in a windmill shape, thus the first green sub-pixel SP1-2 may be disposed adjacent to the second blue sub-pixel SP2-3, and the first white sub-pixel SP1-4 may be disposed adjacent to the second red sub-pixel SP2-1.

The plurality of third sub-pixels SP3 includes a third red sub-pixel SP3-1, a third green sub-pixel SP3-2, a third blue sub-pixel SP3-3, and a third white sub-pixel SP3-4. The third red sub-pixel SP3-1 is disposed in the first direction D1. The third green sub-pixel SP3-2 is disposed adjacent to the third red sub-pixel SP3-1 and disposed in the first direction D1. The third blue sub-pixel SP3-3 is disposed partially adjacent to each of one side of the third red sub-pixel SP3-1 and one side of the third green sub-pixel SP3-2 and disposed in the second direction D2. The third white sub-pixel SP3-4 is disposed partially adjacent to each of the other side of the third red sub-pixel SP3-1 and the other side of the third green sub-pixel SP3-2 and disposed in the second direction D2. One side of the third red sub-pixel SP3-1 may refer to a left lower side of the third red sub-pixel SP3-1 with respect to FIG. 2. The other side of the third red sub-pixel SP3-1 may refer a right upper side of the third red sub-pixel SP3-1 with respect to FIG. 2. Thus, in the transparent display apparatus 100 according to one aspect of the present disclosure, the third red sub-pixel SP3-1, the third green sub-pixel SP3-2, the third blue sub-pixel SP3-3, and the third white sub-pixel SP3-4 may be disposed in a windmill shape or an X shape.

On the other hand, as shown in FIG. 2, each of the plurality of first sub-pixels SP1 and the plurality of third sub-pixels SP3 may be disposed in a windmill shape, thus the first green sub-pixel SP1-2 is disposed adjacent to the third white sub-pixel SP3-4, and the first blue sub-pixel SP1-3 is disposed adjacent to the third red sub-pixel SP3-1.

The transparent display apparatus 100 according to one aspect of the present disclosure may comprise the plurality of first sub-pixels SP1, the plurality of second sub-pixels SP2, and the plurality of third sub-pixels SP3, each of which is disposed in the form of a windmill, and one sub-pixel of the plurality of first sub-pixels SP1, one sub-pixel of the plurality of second sub-pixels SP2, and one sub-pixel of the plurality of third sub-pixels SP3 may be disposed adjacent to each other. Accordingly, the transparent display apparatus 100 according to one aspect of the present disclosure may be configured to emit the second sub-pixel SP2 of the same color and the third sub-pixel SP3 of the same color when one first sub-pixel SP1 of the plurality of first sub-pixels SP1 is a sub-pixel where the dark point occurred, thus the first sub-pixel SP1 where the dark point occurred may be minimized or prevented from being perceived by a user.

In other words, the transparent display apparatus 100 according to one aspect of the present disclosure may drive the same-colored sub-pixels of two other adjacent pixels in place of the sub-pixel where the dark point occurred, thus the image to be expressed in a particular pixel may be expressed using the adjacent pixels. The driving method mentioned above is defined herein as visual rendering driving.

The transparent display apparatus 100 according to one aspect of the present disclosure may implement a visual rendering drive by dividing the data value of the sub-pixel where the dark point occurred, and further reflecting the divided data values to the data values of each of the sub-pixels that emit light of the same color in adjacent pixels.

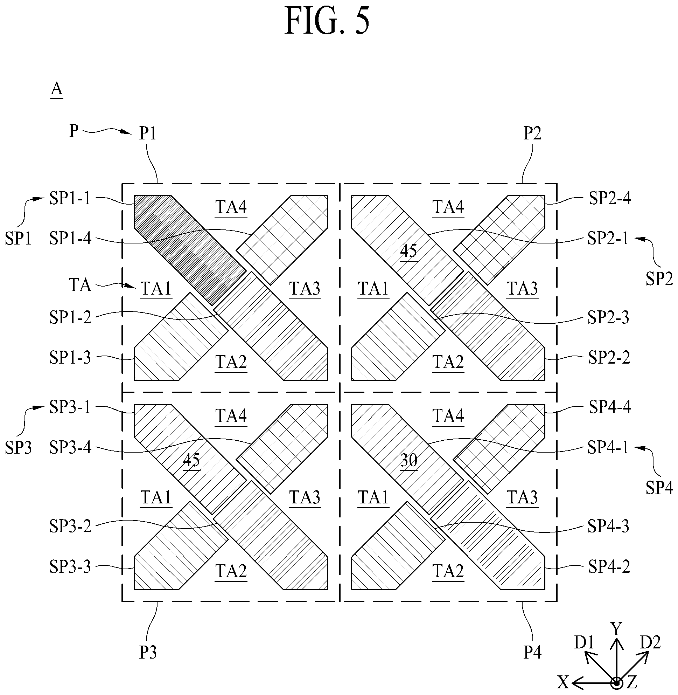

For example, when the first red sub-pixel SP1-1 is sub-pixel where the dark point occurred, the second red sub-pixel SP2-1 and the third red sub-pixel SP3-1 may emit light in place of the first red sub-pixel SP1-1. In this case, the data value of the first red sub-pixel SP1-1 may be divided and the divided data values are respectively added to the data value of each of the second red sub-pixel SP2-1 and the third red sub-pixel SP3-1. Thus, the transparent display apparatus 100 according to one aspect of the present disclosure may drive the same-colored sub-pixels of the other two adjacent pixels in place of the sub-pixel where the dark point occurred, thus the user's perceptibility of the sub-pixel where the dark point occurred may be minimized. This will be described further in connection with FIG. 5.

Hereinafter, with reference to FIGS 2 to 4, one pixel P1 included in the transparent display apparatus 100 according to one aspect of the present disclosure will be described in detail.

Referring to FIGS. 2 and 3, the first pixel P1 according to one example may include the plurality of first sub-pixels SP1. The plurality of first sub-pixels SP1 may include the first red sub-pixel SP1-1 and the first green sub-pixel SP1-2, the first blue sub-pixel SP1-3 and the first white sub-pixel SP1-4. The first red sub-pixel SP1-1 and the first green sub-pixel SP1-2 are disposed adjacent each other in the first direction D1, and the first blue sub-pixel SP1-3 and the first white sub-pixel SP1-4 are disposed adjacent in the second direction D2. The first blue sub-pixel SP1-3 may be disposed partially adjacent to each of one side of the first red sub-pixel SP1-1 and the first green sub-pixel SP1-2. The first white sub-pixel SP1-4 may be disposed partially adjacent to each of the other side of the first red sub-pixel SP1-1 and the other side of the first green sub-pixel SP1-2. Thus, the first red sub-pixel SP1-1, the first green sub-pixel SP1-2, the first blue sub-pixel SP1-3, and the first white sub-pixel SP1-4 may be disposed in a windmill shape or an X shape.

Each of the first red sub-pixel SP1-1, the first green sub-pixel SP1-2, the first blue sub-pixel SP1-3, and the first white sub-pixel SP1-4 may include the light emission area EA and a circuit area. Since the transparent display apparatus 100 according to one aspect of the present disclosure is configured in an upper light emission method, the circuit area may be disposed below the pixel electrode 114, as shown in FIG. 3. In other words, the circuit area may be disposed to overlap the pixel electrode 114 (or the light emission area EA) in the Z-axis direction.

The first red sub-pixel SP1-1 according to one example may include a first light emission area EA1. The first green sub-pixel SP1-2 may include a second light emission area EA2. The first blue sub-pixel SP1-3 may include a third light emission area EA3. The first white sub-pixel SP1-4 may include a fourth light emission area EA4.

Referring to FIG. 3, each of the first red sub-pixel SP1-1, the first green sub-pixel SP1-2, the first blue sub-pixel SP1-3, and the first white sub-pixel SP1-4 may be provided with a light emitting element and a circuit element including a thin film transistor and a capacitor R2, G2, B2, W2. The thin film transistors may include drive transistors R1, G1, B1, W1 (or 112), scan transistors R3, G3, B3, W3, and sense transistors R4, G4, B4, W4.

The scan transistors R3, G3, B3, W3 is switched according to the scan signal supplied to the gate line GL (or scan line GL) to supply the data voltage supplied from the data lines DL1, DL2, DL3, DL4 to the drive transistors R1, G1, B1, W1.

The sense transistors R4, G4, B4, W4 sense threshold voltage deviations of the drive transistors R1, G1, B1, W1 that cause image degradation.

The drive transistors R1, G1, B1, W1 are switched according to the data voltage supplied from the scan transistor to generate a data current from the power supplied from the pixel power line EVDD and supply it to the pixel electrodes 114 of the sub-pixel. Each of the drive transistors R1, G1, B1, and W1 (or drive transistor 112) includes an active layer 112a, a gate electrode 112b, a source electrode 112c, and a drain electrode 112d.

The capacitors R2, G2, B2, W2 maintain the data voltage supplied to the drive transistors R1, G1, B1, W1 (or 112) for one frame. Each of the capacitors R2, G2, B2, W2 may include a first capacitor electrode and a second capacitor electrode.

In detail, referring to FIG. 4, the active layer 112a may be provided over the substrate 110. The active layer 112a may be formed of a silicon based semiconductor material or an oxide based semiconductor material.

A light-shielding layer LS may be provided between the active layer 112a and the first substrate 110. The light-shielding layer LS may serve as a light shielding layer for shielding external light entering the active layer 112a. The light-shielding layer LS may be made of a conductive material. For example, the light-shielding layer LS may be formed of a single layer or a multi-layer made of one of Mo, Al, Cr, Au, Ti, Ni, Nd and Cu, or their alloy. In this case, a buffer layer BL may be provided between the light-shielding layer LS and the active layer 112a.

A gate insulating layer 111a may be provided over the active layer 112a. The gate insulating layer 111a may be formed of an inorganic film such as a silicon oxide film (SiOx) and a silicon nitride film (SiNx) or a multi-layered film of SiOx and SiNx.

The gate electrode 112b may be provided over the gate insulating layer 111a. The gate electrode 112b may be formed of a single layer or a multi-layer made of any one of Mo, Al, Cr, Au, Ti, Ni, Nd and Cu, or their alloy.

An inter-layer dielectric layer 111b may be provided over the gate electrode 112b. The inter-layer dielectric layer 111b may be made of an inorganic film such as a silicon oxide film (SiOx) and a silicon nitride film (SiNx) or a multi-layered film of SiOx and SiNx.

The source electrode 112c SE and the drain electrode 112d may be provided over the inter-layer dielectric layer 111b. The source electrode 112c and the drain electrode 112d may be connected to the active layer 112a through a contact hole passing through the gate insulating layer 111a and the inter-layer dielectric layer 111b.

The source electrode 112c and the drain electrode 112d may be made of a single layer or a multi-layer of any one of Mo, Al, Cr, Au, Ti, Ni, Nd and Cu, or their alloy. The drain electrode 112d may be connected to the pixel electrode 114 through a connection electrode CE that penetrates a first passivation layer 111c. The connection electrode CE may be connected to the drain electrode 112d or source electrode 112c of the drive transistors R1, G1, B1, W1 (or 112) through the second contact hole CNT2.

The first passivation layer 111c may be provided on the source electrode 112c and the drain electrode 112d to protect the drive transistors R1, G1, B1, W1 (or 112).

The first passivation layer 111c may be disposed between the substrate 110 and the planarization layer 113. The first passivation layer 111c, according to one example, covers the drain electrode 112d and the source electrode 112c of the drive transistor 112 and the interlayer insulating layer 111b. The first passivation layer 111c may be formed throughout the circuit area and the light emission area EA.

A second passivation layer 111d may be disposed on the substrate 110 to cover a pixel P. For example, the second passivation layer 111d may be disposed between the first passivation layer 111c and the planarization layer 113 to cover the connection electrode CE. The second passivation layer 111d may be formed throughout the circuit region and the light emission area EA. The connection electrode CE according to one example may be clad.

The planarization layer 113 may be provided on the second passivation layer 111d for planarizing a step difference caused by the drive transistors R1, G1, B1, W1 (or 112). The planarization layer 113 may be formed of an organic film such as an acrylic resin, an epoxy resin, a phenolic resin, a polyamide resin, a polyimide resin, or the like.

The gate insulating layer 111a, the interlayer insulating layer 11 1b, the first passivation layer 111c, and the second passivation layer 111d may be included in an inorganic layer 111.

The bank 115 and a light emitting elements comprising pixel electrodes 114, organic emitting layer 116, and opposing electrodes 117 is provided on the planarization layer 113.

The pixel electrode 114 may be provided on the planarization layer 113 and connected to the drive transistors R1, G1, B1, W1, or 112 through the connection electrode CE. Specifically, the pixel electrode 114 may be connected to the source electrode 112c or the drain electrode 112d of the drive transistors R1, G1, B1, W1 (or 112) through the first contact hole CNT1 penetrating the planarization layer 113 and the second passivation layer 111d. Accordingly, the pixel electrodes 114 may be electrically connected to the drive transistors R1, G1, B1, W1 (or 112).

Such pixel electrodes 114 may be provided for each of sub-pixels SP1-1, SP1-2, SP1-3, SP1-4. One pixel electrode 114 may be formed in the first red sub-pixel SP1-1, another pixel electrode 114 may be formed in the first green sub-pixel SP1-2, still another pixel electrode 114 may be formed in the first blue sub-pixel SP1-3, and yet another pixel electrode 114 may be formed in the first white sub-pixel SP1-4. Also, the pixel electrode 114 is not provided in the transmissive portion TA (or the first to fourth transmissive portions TA1, TA2, TA3, TA4).

The pixel electrode 114 may be formed of a metal material of high reflectivity such as a deposited structure (Ti /Al/Ti) of aluminum and titanium, a deposited structure (ITO/Al/ITO) of aluminum and ITO, an Ag alloy and a deposited structure (ITO/Ag alloy/ITO) of Ag alloy and ITO, MoTi alloy and a deposited structure (ITO/MoTi alloy/ITO) of MoTi alloy and ITO. The Ag alloy may be an alloy of silver (Ag), palladium (Pb), and Copper (Cu). The MoTi alloy may be an alloy of molybdenum (Mo) and titanium (Ti). The pixel electrode 114 may be an anode electrode or a first electrode.

In the transparent display apparatus 100 according to one aspect of the present disclosure, the one end of the first red sub-pixel SP1-1 may be provided in a protruding shape, and the other end of the first red sub-pixel SP1-1 may be provided in a shape different from the one end. For example, as shown in FIG. 3, the one end of the first red sub-pixel SP1-1 may be provided in a triangular shape, and the other end may be provided in a straight line shape. The one end of the first red sub-pixel SP1-1 may be a portion of the first red sub-pixel SP1-1 that is adjacent to a sub-pixel SP of another pixel P. The other end of the first red sub-pixel SP1-1 may be a portion of the first red sub-pixel SP1-1 that is adjacent to another sub-pixel SP of the same pixel P, for example, a portion of the first red sub-pixel SP1-1 that is adjacent to the first green sub-pixel SP1-2.

The one end of the first red sub-pixel SP1-1 provided in a protruding shape is to be disposed adjacent to each of the protruding ends of the blue sub-pixel of another pixel, and the protruding ends of the white sub-pixel of another pixel. Since each of the sub-pixels having different colors is provided in a protruding shape, the sub-pixels of different pixels may be disposed in close proximity, thereby minimizing the size (or area) of the non-light emission area NEA where no light is emitted.

Further, since each of the sub-pixels having a different color is provided in a protruding shape, sub-pixels having different colors may be disposed in close proximity, so that two sub-pixels having the same color may be emitted in close proximity to a sub-pixel where the dark point occurs, thereby minimizing the visibility of the dark point to the user.

In other words, the transparent display apparatus 100 according to one aspect of the present disclosure is configured such that when the dark point occurs in a sub-pixel SP included in one of the pixels P, the same-colored sub-pixel SP included in each of other two pixels P emits light via a visual rendering drive, thereby minimizing the perceptibility of the sub-pixel where the dark point occurs.

In the case of a general transparent display apparatus, since the sub-pixel included in a pixel is disposed adjacent to only one sub-pixel of another pixel, when the dark point occurs in the sub-pixel, only the adjacent one sub-pixel may be emitted. Therefore, the adjacent one sub-pixel has to emit up to the data value of the sub-pixel where the dark point occurs, which not only requires a high power but also causes a problem that the emitting sub-pixel is subjected to a high driving stress, which reduces the service life.

In contrast, the transparent display apparatus 100 according to one aspect of the present disclosure is configured with at least two sub-pixels (or shared sub-pixels) emitting the same color as the sub-pixel where the dark point occurs, so that one sub-pixel (or one shared sub-pixel) may be driven at a lower power than in the case of a conventional transparent display apparatus in which only one sub-pixel of the same color is emitted, thereby reducing the overall power consumption, and minimizing or preventing the reduction in service life.

As a result, the transparent display apparatus 100 according to one aspect of the present disclosure is configured so that one end of the first red sub-pixel SP1-1 is provided in a protruding shape, and the other end of the first red sub-pixel SP1-1 is provided in a shape different from the one end. Accordingly, the sub-pixels of the different pixels may be disposed close together, the size (or area) of the non-light emission area NEA may be minimized, and the perceptibility of the sub-pixel where the dark point occurs may be minimized by driving the visual rendering when the dark point occurs, thereby providing a high quality image.

On the other hand, since the other ends of each of the plurality of first sub-pixels SP1 (or first red sub-pixel SP1-1, first green sub-pixel SP1-2, first blue sub-pixel SP1-3, and first white sub-pixel SP1-4) are in a straight line shape, the plurality of first sub-pixels SP1 may be disposed adjacent to each other while minimizing the size (or area) of the non-light emission area NEA, as shown in FIG. 3.

On the other hand, each of the first green sub-pixel SP1-2, the first blue sub-pixel SP1-3, and the first white sub-pixel SP1-4 that are included in the first pixel P1 has the same structure as the first red sub-pixel SP1-1, so a description of them will be omitted.

Referring again to FIG. 4, the bank 115 may be provided on the planarization layer 113. Further, the banks 115 may be provided between the pixel electrodes 114 Also, the bank 115 may be formed such that it covers an edge of each of the pixel electrodes 114 and a portion of each of the pixel electrodes 114 is exposed. Accordingly, since the thickness of the organic light emitting layer 116 becomes thinner at each of the ends of the pixel electrodes 114, the bank 115 may prevent the pixel electrodes 114 and the opposing electrodes 117 from contacting.

The bank 115 may define light emission areas EA1, EA2, EA3, EA4 for each of the first red sub-pixel SP1-1, the first green sub-pixel SP1-2, the first blue sub-pixel SP1-3, and the first white sub-pixel SP1-4. The light emission areas EA1, EA2, EA3, EA4 of each of the sub-pixels SP1-1, SP1-2, SP1-3, SP1-4 represent areas where the pixel electrode 114, the organic light emitting layer 116, and the opposing electrode 117 are stacked sequentially so that holes from the pixel electrode 114 and electrons from the opposing electrode 117 are combined with each other in the organic light emitting layer 116 and emit light. In this case, the area where the bank 115 is formed does not emit light and thus becomes the non-light emission area NEA, and the area where the bank 115 is not formed and the pixel electrode 114 is exposed may become the light emission area EA1, EA2, EA3, EA4. However, it is not necessarily limited thereto, and as shown in FIG. 4, when the bank 115 partially overlaps the transmissive portion TA, the non-light emission area NEA may refer to the area where a black matrix BM is disposed.

The bank 115 may be formed of an organic layer, for example, acryl resin, epoxy resin, phenolic resin, polyamide resin, polyimide resin, etc.

The organic light emitting layer 116 may be provided over the pixel electrode 114. The organic light emitting layer 116 may include a hole transporting layer, a light emitting layer, and an electron transporting layer. In this case, if a voltage is applied to the pixel electrode 114 and the opposing electrode 117, holes and electrons move to the light emitting layer through the hole transporting layer and the electron transporting layer, respectively, and are combined with each other in the light emitting layer to emit light.

In one aspect, the organic light emitting layer 116 may be a common layer formed common to the first red sub-pixel SP1-1, the first green sub-pixel SP1-2, the first blue sub-pixel SP1-3, and the first white sub-pixel SP1-4. In this case, the light-emitting layer may be a white light-emitting layer that emits white light.

In other aspects, the light emitting layer of the organic light emitting layer 116 may be formed for each of the first red sub-pixel SP1-1, the first green sub-pixel SP1-2, the first blue sub-pixel SP1-3, and the first white sub-pixel SP1-4. In one example, a red light-emitting layer emitting red light may be formed in the first red sub-pixel SP1-1, a green light-emitting layer emitting green light may be formed in the first green sub-pixel SP1-2, a blue light-emitting layer emitting blue light may be formed in the first blue sub-pixel SP1-3, and a white light-emitting layer emitting white light may be formed in the first white sub-pixel SP1-4. In such a case, the light emitting layer of the organic light emitting layer 116 is not formed in the transmissive portion TA.

The opposing electrode 117 may be provided over the organic light emitting layer 116 and the bank 115. The opposing electrodes 117 may be provided in the light emission area EA and the non-light emission area NEA, as well as in the transmissive portion TA, but are not necessarily limited thereto. The opposing electrodes 117 may be provided only in the light emission area EA and the non-light emission area NEA, and may not be provided in the transmissive portion TA to improve the transmittance.

Such opposing electrodes 117 may be a common layer formed common to the first red sub-pixel SP1-1, the first green sub-pixel SP1-2, the first blue sub-pixel SP1-3, and the first white sub-pixel SP1-4 to apply the same voltage. The opposing electrodes 117 may be made of a conductive material capable of transmitting light. In one example, the opposing electrodes 117 may be formed of a low resistivity metallic material, such as silver (Ag), or an alloy of magnesium (Mg) and silver (Ag). The opposing electrode 117 may be a cathode electrode or a second electrode.

An encapsulation layer 118 may be provided over the light emitting diodes. The encapsulation layer 118 may be provided over the opposing electrode 117 to overlay the opposing electrode 117. The encapsulation layer 118 serves to prevent oxygen or water from being permeated into the organic light emitting layer 116 and the opposing electrode 117. To this end, the encapsulation layer 118 may include at least one inorganic layer and at least one organic layer.

Meanwhile, although not shown in FIG. 4, a capping layer may additionally be provided between the opposing electrode 117 and the encapsulation layer 118.

A color filter CF may be provided over the encapsulation layer 118. The color filter CF may be provided over one surface of the opposing substrate 200 that faces the substrate 110. In this case, the substrate 110 provided with the encapsulation layer 118 and the opposing substrate 200 provided with the color filter CF may be bonded to each other by an adhesive layer (not shown). The adhesive layer according to one example may be an optically clear resin (OCR) layer or an optically clear adhesive (OCA) film.

The color filter CF may be patterned by a first red sub-pixel SP1-1, a first green sub-pixel SP1-2, a first blue sub-pixel SP1-3, and a first white sub-pixel SP1-4. Specifically, the color filter CF may include a first color filter, a second color filter, and a third color filter. The first color filter CF1 may be disposed to correspond to the first light emission area EA1 of the first red sub-pixel SP1-1, and may be a red color filter that transmits red light. The second color filter may be disposed to correspond to the second light emission area EA2 of the first green sub-pixel SP1-2, and may be a green color filter that transmits green light. The third color filter may be disposed to correspond to the third light emission area EA3 of the first blue sub-pixel SP1-3, and may be a blue color filter that transmits blue light. The color filter CF may further comprise a fourth color filter disposed to correspond to the fourth light emission area EA4 of the first white sub-pixels SP1-4, which are white sub-pixels. In such a case, the fourth color filter may comprise a transparent organic material that transmits white light. Alternatively, if the organic light emitting layer 116 is configured to emit white light, the first white sub-pixels SP1-4 may not be provided with a color filter.

The black matrix BM may be provided between the color filters CF and between the color filters CF and the transmissive portion TA (or a first transmissive portion TA1). The black matrix BM may be provided between the first red sub-pixel SP1-1, the first green sub-pixel SP1-2, the first blue sub-pixel SP1-3, and the first white sub-pixel SP1-4 to prevent color mixing between adjacent sub-pixels.

The black matrix BM may include a light-absorbing material, such as a black dye, which absorbs all light in the visible wavelength range.

Hereinafter, referring to FIG. 3, a structure of a pixel P included in a transparent display apparatus 100 according to one aspect of the present disclosure will be described in detail, and an example in which the data lines DL1, DL2, DL3, DL4, the pixel power lines EVDD, the common power lines EVSS, and the drive transistors R1, G1, B1, W1) (or 112) included in the pixel P are disposed.

As described above, the display area DA includes the plurality of pixels P, and each of the plurality of pixels P includes the plurality of sub-pixels SP and the plurality of transmissive portions TA. Each of the plurality of sub-pixels SPs may include the light emission area EA and the non-light emission area NEA.

For example, the plurality of sub-pixels SPs included in the first pixel P1 may include two sub-pixels SPs disposed in the first direction D1 (or the first red sub-pixel SP1-1 and the first green sub-pixel SP1-2), and two sub-pixels SPs disposed in the second direction D2 (or the first blue sub-pixel SP1-3 and the first white sub-pixel SP1-4).

The plurality of transmissive portions TAs included in the first pixel P1 include the first transmissive portion TA1 disposed between the first red sub-pixel SP1-1 and the first blue sub-pixel SP1-3, a second transmissive portion TA2 disposed between the first blue sub-pixel SP1-3 and the first green sub-pixel SP1-2, a third transmissive portion TA3 disposed between the first green sub-pixel SP1-2 and the first white sub-pixel SP1-4, and a fourth transmissive portion TA4 disposed between the first white sub-pixel SP1-4 and the first red sub-pixel SP1-1.

As shown in FIG. 3, each of the first transmissive portion TA1, the second transmissive portion TA2, the third transmissive portion TA3, and the fourth transmissive portion TA4 may be disposed in a triangular shape. By disposing the plurality of sub-pixels SPs in a windmill shape and disposing the triangular transmissive portions TA between the plurality of sub-pixels SPs, the first pixel P1 may be configured in a square shape. Further, since one ends of each of the plurality of sub-pixels SPs are provided in a protruding shape, the plurality of sub-pixels P may be disposed close together while minimizing the size (or area) of the non-light emission area NEA.

Meanwhile, each of the plurality of pixels P may include a center area CTA. For example, the first pixel P may include the center area CTA where the first red sub-pixel SP1-1, the first green sub-pixel SP1-2, the first blue sub-pixel SP1-3, and the first white sub-pixel SP1-4 are disposed adjacent to each other. The center area CTA according to one example may be an area where the other ends of each of the pixel electrode 114 of the first red sub-pixel SP1-1, the pixel electrode 114 of the first green sub-pixel SP1-2, the pixel electrode 114 of the first blue sub-pixel SP1-3, and the pixel electrode 114 of the first white sub-pixel SP1-4 in a straight line shape are disposed adjacent each other, as shown in FIG. 3. Thus, the center area CTA may be an area including the center of each of the plurality of pixels P.

In the transparent display apparatus 100 according to one aspect of the present disclosure, the first transmissive portion TA1 may be configured to have a shape symmetrical to the third transmissive portion TA3 with respect to the center area CTA. Also, the second transmissive portion TA2 may be configured to have a shape symmetrical to the fourth transmissive portion TA4 with respect to the center area CTA. For example, each of the first transmissive portion TA1 and the third transmissive portion TA3 may be configured to have a symmetrical triangular shape with respect to the center area CTA. Further, each of the second transmissive portion TA2 and the fourth transmissive portion TA4 may be configured to have a symmetrical triangular shape with respect to the center area CTA. Accordingly, each of the plurality of pixels P may be configured in a square shape, and the triangularly shaped transmissive portions TA of each pixel may be disposed adjacent to each other by disposing the square-shaped pixels adj acent to each other. Since the plurality of transmissive portions TA adj acent to each other are disposed in a square shape or a diamond shape, the transmissivity may be improved compared to the case in which the plurality of transmissive portions are disposed at a distance from each other.

Referring to FIG. 3, each of the plurality of sub-pixels SPs may be provided with the light emitting element and the circuit element including the thin film transistor, the capacitors R2, G2, B2, W2. The thin film transistors may include the drive transistors R1, G1, B1, W1 (or 112), the scan transistors R3, G3, B3, W3, and the sense transistors R4, G4, B4, W4.

The transparent display apparatus 100 according to one aspect of the present disclosure is configured in an upper light emitting manner, thus the capacitors R2, G2, B2, W2, the drive transistors R1, G1, B1, W1 (or 112), the scan transistors R3, G3, B3, W3, and the sense transistors R4, G4, B4, W4 that are included in each of the plurality of sub-pixels SP may be disposed to overlap the pixel electrode 114 (or light emission area EA) included in each of sub-pixels SP. That is, the capacitors R2, G2, B2, W2, the drive transistors R1, G1, B1, W1 (or 112), the scan transistors R3, G3, B3, W3, and the sense transistors R4, G4, B4, W4 that are included in each of the plurality of sub-pixels SPs may be disposed below the pixel electrodes 114.

Further, each of the data lines DL1, DL2, DL3, DL4, the pixel power lines EVDD, and the common power lines EVSS included in each of the plurality of pixels Ps may partially overlap each of the plurality of sub-pixels SPs.

For example, the first data line DL1 for driving the first red sub-pixel SP1-1 may be disposed to partially overlap the first red sub-pixel SP1-1 and the first blue sub-pixel SP1-3. More specifically, the first data line DL1 may be disposed to partially overlap the pixel electrodes 114 of the first red sub-pixel SP1-1 and the pixel electrodes 114 of the first blue sub-pixel SP1-3. Thus, in the transparent display apparatus 100 according to one aspect of the present disclosure, since the first data line DL1 may be disposed to partially overlap the pixel electrode 114 of the first red sub-pixel SP1-1, and the pixel electrode 114 of the first blue sub-pixel SP1-3, the overlap of the first data line DL1 with the second transmissive portion TA2 and the fourth transmissive portion TA4 may be minimized or prevented.

The first data line DL1 is disposed to extend in the first direction D1 in the first red sub-pixel SP1-1, and to extend in the second direction D2 in the first blue sub-pixel SP1-3, and may be connected to the scan transistor R3 of the first red sub-pixel SP1-1 to supply a data voltage to the first red sub-pixel SP1-1.

The second data line DL2 for driving the first blue sub-pixel SP1-3 may be disposed to partially overlap the first red sub-pixel SP1-1 and the first blue sub-pixel SP1-3 and spaced apart from the first data line DL1. More specifically, the second data line DL2 may be disposed to partially overlap the pixel electrodes 114 of the first red sub-pixel SP1-1 and the pixel electrodes 114 of the first blue sub-pixel SP1-3. Thus, in the transparent display apparatus 100 according to one aspect of the present disclosure, since the second data line DL2 may be disposed to partially overlap the pixel electrodes 114 of the first red sub-pixel SP1-1, and the pixel electrodes 114 of the first blue sub-pixel SP1-3, the overlap of the second data line DL2 with the first transmissive portion TA1 may be minimized or prevented.

The second data line DL2 is disposed to extend in the first direction D1 in the first red sub-pixel SP1-1, and to extend in the second direction D2 in the first blue sub-pixel SP1-3, and may be connected to the scan transistor B3 of the first blue sub-pixel SP1-3 to supply a data voltage to the first blue sub-pixel SP1-3.

The third data line DL3 for driving the first white sub-pixel SP1-4 may be disposed to partially overlap the first white sub-pixel SP1-4 and the first green sub-pixel SP1-2. More specifically, the third data line DL3 may be disposed to partially overlap the pixel electrodes 114 of the first white sub-pixel SP1-4 and the pixel electrodes 114 of the first green sub-pixel SP1-2. Thus, in the transparent display apparatus 100 according to one aspect of the present disclosure, since the third data line DL3 may be disposed to partially overlap the pixel electrodes 114 of the first white sub-pixel SP1-4, and the pixel electrodes 114 of the first green sub-pixel SP1-2, the overlap of the third data line DL3 with the second transmissive portion TA2 and the fourth transmissive portion TA4 may be minimized or prevented.

The third data line DL3 is disposed to extend in the second direction D2 in the first white sub-pixel SP1-4, and to extend in the first direction D1 in the first green sub-pixel SP1-2, and may be connected to the scan transistor W3 of the first white sub-pixel SP1-4 to supply a data voltage to the first white sub-pixel SP1-4.

The fourth data line DL4 for driving the first green sub-pixel SP1-2 may be disposed to partially overlap the first white sub-pixel SP1-4 and the first green sub-pixel SP1-2 and spaced apart from the third data line DL3. More specifically, the fourth data line DL4 may be disposed to partially overlap the pixel electrodes 114 of the first white sub-pixel SP1-4 and the pixel electrodes 114 of the first green sub-pixel SP1-2. Thus, in the transparent display apparatus 100 according to one aspect of the present disclosure, since the fourth data line DL4 may be disposed to partially overlap the pixel electrodes 114 of the first white sub-pixel SP1-4, and the pixel electrodes 114 of the first green sub-pixel SP1-2, the overlap of the fourth data line DL4 with the third transmissive portion TA3 may be minimized or prevented.

The fourth data line DL4 is disposed to extend in the second direction D2 in the first white sub-pixel SP1-4, and to extend in the first direction D1 in the first green sub-pixel SP1-2, and is connected to the scan transistor G3 of the second green sub-pixel SP1-2 to supply a data voltage to the second green sub-pixel SP1-2.

As a result, the transparent display apparatus 100 according to one aspect of the present disclosure may be configured such that the data lines DL1, DL2, DL3, DL4 are disposed to partially overlap the pixel electrodes 114 of each sub-pixel SP, thereby maximizing the transmittance improvement compared to the case in which the data lines are disposed in the transmissive portion.

Referring again to FIG. 3, each of the plurality of pixels P may include the pixel power line EVDD. For example, the first pixel P1 may include the pixel power line EVDD for applying the pixel driving voltage to each of the plurality of first sub-pixels SP1.

As shown in FIG. 3, the pixel power line EVDD disposed in the first pixel P1 may be partially overlapping the center area CTA and may be disposed to overlap each of the plurality of first sub-pixels SP1. More specifically, the pixel power line EVDD may be disposed to extend in the center area CTA in the Y-axis direction and to extend into each of the first red sub-pixel SP1-1, the first green sub-pixel SP1-2, the first blue sub-pixel SP1-3, and the first white sub-pixel SP1-4. The pixel power line EVDD extending into each of the first red sub-pixel SP1-1, the first green sub-pixel SP1-2, the first blue sub-pixel SP1-3, and the first white sub-pixel SP1-4 may be disposed to partially overlap the pixel electrodes 114 of each of the first red sub-pixel SP1-1, the first green sub-pixel SP1-2, the first blue sub-pixel SP1-3, and the first white sub-pixel SP1-4.

The pixel power line EVDD extending into the first red sub-pixel SP1-1 may be connected to the drive transistor R1 of the first red sub-pixel SP1-1 to apply the pixel driving voltage. The pixel power line EVDD extending into the first green sub-pixel SP1-2 may be connected to the drive transistor G1 of the first green sub-pixel SP1-2 to apply the pixel driving voltage. The pixel power line EVDD extending into the first blue sub-pixel SP1-3 may be connected to the drive transistor B1 of the first blue sub-pixel SP1-3 to apply the pixel driving voltage. The pixel power line EVDD extending into the first white sub-pixel SP1-4 may be connected to the drive transistor W1 of the first white sub-pixel SP1-4 to apply the pixel driving voltage.

As a result, in the transparent display apparatus 100 according to one aspect of the present disclosure, the pixel power lines EVDD disposed in the first pixel P1 may be disposed in an X-shape in the first pixel P1. FIG. 3 is an exemplary illustration of the first pixel P1, and each of the plurality of pixels P disposed in the display area DA may be provided with the same structure as the first pixel P1. Accordingly, in the transparent display apparatus 100 according to one aspect of the present disclosure, since the pixel power line EVDD may be disposed to partially overlap the pixel electrodes 114 of each sub-pixel SP, the transmittance is improved compared to a case in which the pixel power line is disposed in the transmissive portion.

On the other hand, the common power line EVSS included in the first pixel P1 may be disposed to partially overlap each of the first green sub-pixel SP1-2 and the first white sub-pixel SP1-4. The common power line EVSS according to an example may be disposed to extend in the first direction D1 in the first green sub-pixel SP1-2 and to extend in the second direction D2 in the first white sub-pixel SP1-4. The common power line EVSS may be connected to the opposing electrodes 117 of the first pixel P1 to apply a common voltage.

The reference line RL included in the first pixel P1 may be disposed to partially overlap each of the first red sub-pixel SP1-1 and the first blue sub-pixel SP1-3. In one example, the reference line RL may be disposed to extend in the first direction D1 in the first red sub-pixel SP1-1 and to extend in the second direction D2 in the first blue sub-pixel SP1-3. The reference line RL may partially overlap the center area CTA. The reference line RL may be connected to the sense transistor R4 of the first red sub-pixel SP1-1 to supply a reference voltage (or initialization voltage, sensing voltage) to the first red sub-pixel SP1-1. The reference line RL may be connected to the sense transistor B4 of the first blue sub-pixel SP1-3 to supply the reference voltage (or initialization voltage, sensing voltage) to the first blue sub-pixel SP1-3. The reference line RL may extend from the center area CTA toward the first white sub-pixel SP1-4 and may be connected to the sense transistor W4 of the first white sub-pixel SP1-4. Thus, the reference line RL may supply the reference voltage (or initialization voltage, sensing voltage) to the first white sub-pixels SP1-4. The reference line RL may extend from the center area CTA toward the first green sub-pixel SP1-2 and may be connected to the sense transistor G4 of the first green sub-pixel SP1-2. Thus, the reference line RL may supply the reference voltage (or initialization voltage, sensing voltage) to the first green sub-pixel SP1-2.

In the transparent display apparatus 100 according to one aspect of the present disclosure, since the common power line EVSS is disposed to partially overlap the pixel electrodes 114 of each of the first green sub-pixel SP1-2 and the first white sub-pixel SP1-4, the transmittance may be improved compared to the case in which the common power line is disposed in the transmissive portion. Furthermore, in the transparent display apparatus 100 according to one aspect of the present disclosure, since the reference line RL is disposed to partially overlap the pixel electrodes 114 of each of the first red sub-pixel SP1-1 and the first blue sub-pixel SP1-3, the transmittance may be improved compared to the case in which the reference line is disposed in the transmissive portion.

Referring again to FIG. 3, the gate line GL may be disposed to extend in the second direction D2 in the first blue sub-pixel SP1-3 to partially overlap with the pixel electrodes 114 of the first blue sub-pixel SP1-3, may be disposed in a circular or square shape in the center area CTA, and may be disposed to extend in the first direction D1 in the first green sub-pixel SP1-2 to partially overlap the pixel electrodes 114 of the first green sub-pixel SP1-2.

According to one example, the gate line GL may extend from the center area CTA to the first red sub-pixel SP1-1 and be connected to the scan transistor R3 and the sense transistor R4 of the first red sub-pixel SP1-1. Further, the gate line GL may extend from the center area CTA to the first green sub-pixel SP1-2 and may be connected to the scan transistor G3 and the sense transistor G4 of the first green sub-pixel SP1-2. Further, the gate line GL may extend from the center area CTA to the first blue sub-pixel SP1-3 and may be connected to the scan transistor B3 and the sense transistor B4 of the first blue sub-pixel SP1-3. Further, the gate line GL may extend from the center area CTA to the first white sub-pixel SP1-4 and may be connected to the scan transistor W3 and the sense transistor W4 of the first white sub-pixel SP1-4. Accordingly, the gate line GL may supply a gate signal to each of the plurality of sub-pixels SPs included in the first pixel P1.

As a result, the transparent display apparatus 100 according to one aspect of the present disclosure is configured such that the plurality of wires are disposed to partially overlap the plurality of sub-pixels SPs in a limited space, thereby minimizing the overlap of the plurality of wires with the transmissive portion TA, which may result in improved transmittance compared to a case in which the plurality of wires are disposed on the transmissive portion.

Furthermore, in the case of another typical transparent display apparatus, a repair wiring connecting to each of the plurality of sub-pixels (or divided sub-pixels) may be disposed in the transmissive portion to prevent driving of the sub-pixel where the dark point has occurred. In this case, the repair wiring is connected to the pixel electrodes of each of the at least two divided sub-pixels and is thus disposed in the shape of a trident. Due to the trident-shaped repair wiring disposed in the transmissive portion, the diffraction phenomenon of light passing through the transmissive portion may be intensified, thereby reducing the visibility of the background or image on the back of the transparent display apparatus.

In contrast, the transparent display apparatus 100 according to one aspect of the present disclosure is configured such that the sub-pixels SPs included in each of the three different pixels Ps are disposed adjacent to each other, thus the same-colored sub-pixels SPs of each of the two adjacent pixels in place of the sub-pixel SP where the dark point occurs may emit light by the visual rendering drive, thereby minimizing the perceptibility of the sub-pixel where the dark point occurs.

Therefore, the transparent display apparatus 100 according to one aspect of the present disclosure may improve visibility of a background or image because the repair wiring for preventing driving of a sub-pixel where the dark point occurs may be omitted from the transmissive portion, and thus, compared to a case in which the repair wiring is disposed in the transmissive portion, reduced visibility due to diffraction phenomenon may be prevented. Furthermore, the transparent display apparatus 100 according to one aspect of the present disclosure may be configured such that the plurality of wiring for driving each of the plurality of pixels P does not overlap or only minimally overlap in the transmissive portion TA, thus the transmittance of the transmissive portion TA may be maximized.

Hereinafter, referring to FIG. 5, the visual rendering drive of the transparent display apparatus 100 according to one aspect of the present disclosure will be described.

FIG. 5 is a schematic diagram illustrating an operational state according to the example of FIG. 2.

As described above, the transparent display apparatus 100 according to one aspect of the present disclosure drive the same-colored sub-pixels of two other adjacent pixels in place of the sub-pixel where the dark point occurs, thus the image desired to be expressed in a particular pixel may be expressed using the adjacent pixels. This driving method is called visual rendering driving.

The visual rendering driving, according to one example, may be implemented by dividing the data value of the sub-pixel in which the dark point occurred, i.e., the sub-pixel where the failure occurred, and respectively adding the divided data values to the data value of each of the two adjacent sub-pixels that emit light of the same color.

For example, as shown in FIG. 5, when the first red sub-pixel SP1-1 of the first pixel P1 is the sub-pixel where the dark point occurs, the second red sub-pixel SP2-1 of the second pixel P2 and the third red sub-pixel SP3-1 of the third pixel P3, adjacent to the first pixel P1, may be driven by dividing the data value normally driving the first red sub-pixel SP1-1 and respectively adding the divided data values to each of their data values.

More specifically, when the first red sub-pixel SP1-1, the second red sub-pixel SP2-1, and the third red sub-pixel SP3-1 are driving normally, suppose that each of the first red sub-pixel SP1-1, the second red sub-pixel SP2-1, and the third red sub-pixel SP3-1 has a data value of 30, in case that the first red sub-pixel SP1-1 is the sub-pixel where the dark point occurs, each of the second red sub-pixel SP2-1 and the third red sub-pixel SP3-1 may be driven to a data value of 45 by dividing the data value of the first red sub-pixel SP1-1 by 1/2 and adding it to the normal data value. Thus, as shown in FIG. 5, each of the second red sub-pixel SP2-1 and the third red sub-pixel SP3-1 may be driven with a data value of 45 in place of the first red sub-pixel SP1-1 where the dark point occurs. For example, the second red sub-pixel SP2-1 and the third red sub-pixel SP3-1 may emit light with a data value of 45 according to an algorithm preset in the timing controller 150. In this case, a fourth red sub-pixel SP4-1 of the fourth pixel P4 may emit light with a normal data value of 30.

However, it is not necessarily limited thereto, and the data value of the first red sub-pixel SP1-1, where the dark point occurs, may be divided into several data values, such as 1/3 and 2/3, or 1/4 and 3/4, respectively and added to the second red sub-pixel SP2-1 and the third red sub-pixel SP3-1. In this case, the data values of the second red sub-pixel SP2-1 and the third red sub-pixel SP3-1 may be different from each other. For example, the second red sub-pixel SP2-1 may emit light with a data value of 40, and the third red sub-pixel SP3-1 may emit light with a data value of 50.

On the other hand, the second red sub-pixel SP2-1 and the third red sub-pixel SP3-1 may be represented as shared sub-pixels, as they are sub-pixels that emit when a dark point of the first red sub-pixel SP1-1 occurs.

According to one example of the visual rendering driving as described above (when the data value of the sub-pixel where the dark point occurs is divided by 1/2), the final data value of each of the shared sub-pixels may be the sum of the data value of the sub-pixel where the dark point occurs and the data value of each of the N shared sub-pixels (where N is an integer greater than 1), divided by N.. Substituting the above-described example into such a mathematical formula, the final data value of the second red sub-pixel SP2-1 may be 45, which is the sum of the data value of the first red sub-pixel SP1-1, the data value of the second red sub-pixel SP2-1, and the data value of the third red sub-pixel SP3-1, which is 30, divided by 2, which is the number of shared sub-pixels.

As a result, in the transparent display apparatus 100 according to one aspect of the present disclosure, a sub-pixel (or shared sub-pixel) that emits the same color of light in each of the other two pixels adjacent to the pixel containing the dark point may emit light via a manner of the visual rendering driving, thereby minimizing the users' visibility of the sub-pixel where the dark point occurs.

Furthermore, the transparent display apparatus 100 according to one aspect of the present disclosure is configured so that a sub-pixel (or shared sub-pixel) that emits the same color in each of two other adjacent pixels instead of the sub-pixel where the dark point occurs may emit at a higher than normal luminance via a visual rendering driving method, thereby further preventing the users' visibility of the sub-pixel where the dark point occurs to the user, thus providing a high-quality image.

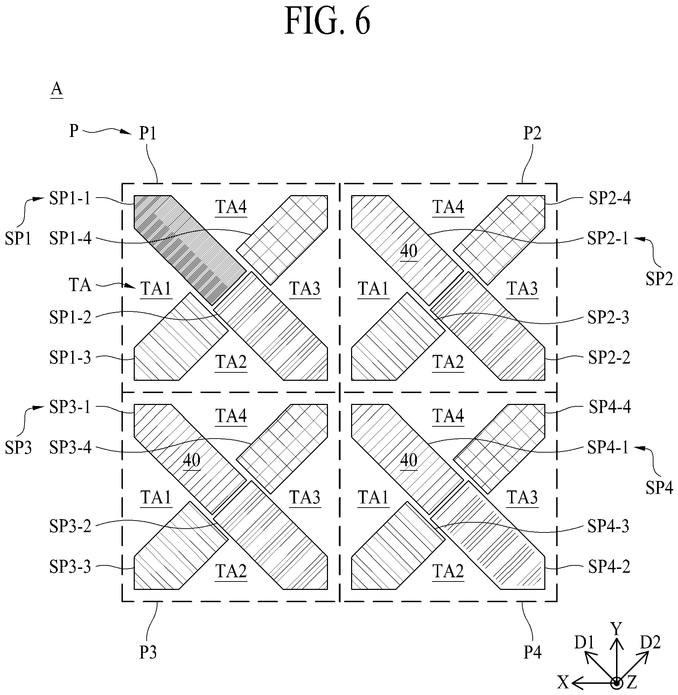

FIG. 6 is a schematic diagram illustrating an operational state according to another example of FIG. 2.

Referring to FIG. 6, the transparent display apparatus 100 according to another example of the present disclosure is identical to the transparent display apparatus according to FIG. 5 above, except for a change in the visual rendering driving. Accordingly, the same drawing symbols have been assigned to the same configurations, and only the different configurations will be described hereinafter.

In the case of the display apparatus according to FIG. 5 mentioned above, since the sub-pixels SP disposed in each of the two second pixels P2 and the third pixel P3 adjacent to the first green sub-pixel SP1-2 of the first pixel P1 is driven through the visual rendering driving, the visibility of the sub-pixel where the dark point occurs may be minimized. In other words, in the case of the display apparatus according to FIG. 5, since the other two sub-pixels instead of the sub-pixel in which the dark point occurs emit light, the visibility of the sub-pixel where the dark point occurs may be minimize.

In contrast, in the case of the display apparatus according to FIG. 6, since the three sub-pixels SP respectively disposed in the second pixels P2, third pixel P3, and fourth pixel P4 adjacent to the first green sub-pixel SP1-2 of the first pixel P1 is driven through the visual rendering driving, the visibility of the sub-pixel in which the dark point occurs may be minimized. For example, the display apparatus according to FIG. 6 may further include the fourth pixel P4 disposed adjacent to the first pixel P1. The fourth pixel P4 according to one example may include a plurality of fourth sub-pixels SP4 and the plurality of transmissive portions TA.

In the case of the display apparatus according to FIG. 6, one first sub-pixel SP1 (e.g., the first green sub-pixel SP1-2) of the plurality of first sub-pixels SP1, one second sub-pixel SP2 (e.g., the second blue sub-pixel SP2-3) of the plurality of second sub-pixels SP2, one third sub-pixel SP3 (e.g., the third white sub-pixel SP3-4) of the plurality of third sub-pixels SP3, and one fourth sub-pixel SP4 (e.g., the fourth red sub-pixel SP4-1) of the plurality of fourth sub-pixels SP4 may be disposed adjacent to each other.

As shown in FIG. 6, the plurality of fourth sub-pixels SP4 according to an example includes the fourth red sub-pixel SP4-1, a fourth green sub-pixel SP4-2, a fourth blue sub-pixel SP4-3, and a fourth white sub-pixel SP4-4. The fourth red sub-pixel SP4-1 is disposed in the first direction D1. The fourth green sub-pixel SP4-2 is disposed adjacent to the fourth red sub-pixel SP4-1 and disposed in the first direction D1. The fourth blue sub-pixel SP4-3 is disposed partially adjacent to each of one side of the fourth red sub-pixel SP4-1 and one side of the fourth green sub-pixel SP4-2 and disposed in the second direction D2. The fourth white sub-pixel SP4-4 is disposed partially adjacent to each of the other side of the fourth red sub-pixel SP4-1 and the other side of the fourth green sub-pixel SP4-2 and disposed in the second direction D2. Here, the first green sub-pixel SP1-1 may be disposed adjacent to the fourth red sub-pixel SP4-1.

Thus, the transparent display apparatus 100 according to another example of the present disclosure may be configured to cause the second red sub-pixel SP2-1, the third red sub-pixel SP3-1, and the fourth red sub-pixel SP4-1 to emit in place of the first red sub-pixel SP1-1 when the first red sub-pixel SP1-1 is the sub-pixel where the dark point occurs, thereby maximizing the prevention of visibility of the sub-pixel where the dark point occurs compared to the case where there are two shared sub-pixels.

For example, suppose the data value for each of the first red sub-pixel SP1-1, second red sub-pixel SP2-1, third red sub-pixel SP3-1, and fourth red sub-pixel SP4-1 is 30 when each of the first red sub-pixel SP1-1, the second red sub-pixel SP2-1, the third red sub-pixel SP3-1, and the fourth red sub-pixel SP4-1 is driving normally, in case that the first red sub-pixel SP1-1 is the sub-pixel where the dark point occurs, each of the second red sub-pixel SP2-1, the third red sub-pixel SP3-1, and the fourth red sub-pixel SP4-1 may be driven to a data value of 40 by dividing the data value of the first red sub-pixel SP1-1 by 1/3 and adding it to the normal data value. Thus, as shown in FIG. 6, each of the second red sub-pixel SP2-1, the third red sub-pixel SP3-1, and the fourth red sub-pixel SP4-1 may be driven with a data value of 40 in place of the first red sub-pixel SP1-1.

Each of the second red sub-pixel SP2-1, the third red sub-pixel SP3-1, and the fourth red sub-pixel SP4-1 may emit light by supplying a data value of 40 according to an algorithm preset in the timing controller 150.

As a result, in the transparent display apparatus 100 according to another example herein, the data value of the first red sub-pixel SP1-1 may be divided and the divided data values may be respectively added to the data value of each of the second red sub-pixel SP2-1, the third red sub-pixel SP3-1 and the fourth red sub-pixel SP4-1.

Thus, the transparent display apparatus 100 according to other examples of the present disclosure may be configured to have three shared sub-pixels emit, thereby reducing the brightness difference with neighboring sub-pixels while lowering the data voltage of each of the shared sub-pixels compared to the case where two shared sub-pixels emit. Thus, the transparent display apparatus 100 according to other examples of the present disclosure may minimally reduce the visibility of the sub-pixels where the dark point occurs, and the service life of the shared sub-pixels may be improved compared to the case where two shared sub-pixels are emitting.

On the other hand, in the transparent display apparatus 100 according to another example of the present disclosure, the data value of the first red sub-pixel SP1-1, which is the sub-pixel where the dark point occurs, may be divided into several data values, such as 1/4 and 2/4 and 1/4, or 1/6 and 2/6 and 3/6, and the divided data values are respectively added to the data value of each of the second red sub-pixel SP2-1, the third red sub-pixel SP3-1 and the fourth red sub-pixel SP4-1. In this case, the data value of each of the second red sub-pixel SP2-1, the third red sub-pixel SP3-1, and the fourth red sub-pixel SP4-1 may be different from each other. For example, when the data value of the first red sub-pixel SP1-1, which is the sub-pixel where the dark point occurs, is divided into 1/6 and 2/6 and 3/6, the second red sub-pixel SP2-1 may emit with a data value of 35, the third red sub-pixel SP3-1 may emit with a data value of 40, and the fourth red sub-pixel SP4-1 may emit with a data value of 45.

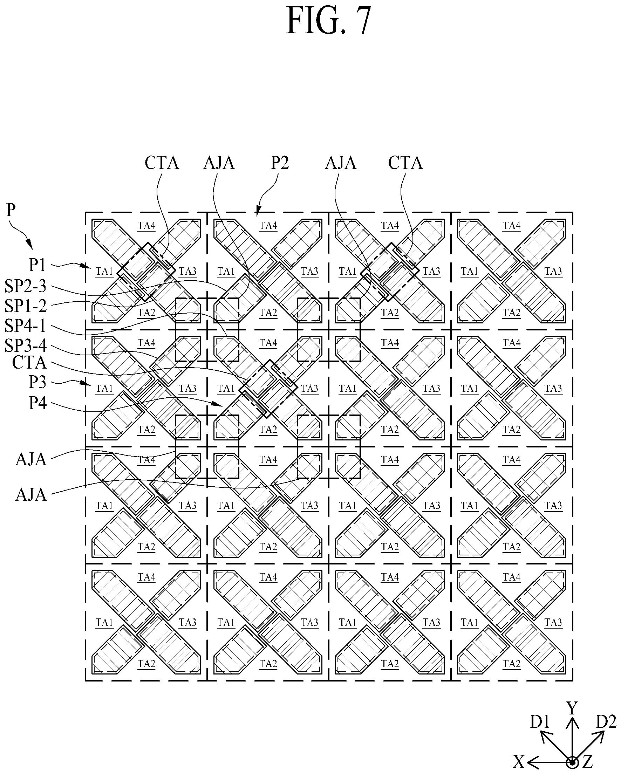

FIG. 7 is a plan view schematically illustrating a portion of a display area of a transparent display apparatus according to one aspect of the present disclosure.

Referring to FIG. 7, the transparent display apparatus 100 according to one aspect of the present disclosure may further include an adjacent area AJA in which sub-pixels of each of the four different pixels P are disposed adjacent to each other. The adjacent area AJA according to one example may be an area in which the first green sub-pixel SP1-2 of the first pixel P1, the second blue sub-pixel SP2-3 of the second pixel P2, the third white sub-pixel SP3-4 of the third pixel P3, and the fourth red sub-pixel SP4-1 of the fourth pixel P4 are disposed adjacent to each other.

As described above, the center area CTA may be an area in which the first red sub-pixel SP1-1, the first green sub-pixel SP1-2, the first blue sub-pixel SP1-3, and the first white sub-pixel SP1-4 are disposed adjacent to each other.

Thus, the transparent display apparatus 100 according to one aspect of the present disclosure may have a structural feature in which the adjacent area AJA and the center area CTA are alternately disposed in the first direction D1 or the second direction D2. Such a structure may be equally implemented to the transparent display apparatus 100 according to other aspects of the present disclosure.

In the transparent display apparatus 100 according to one aspect of the present disclosure, the size (or area) of the non-light emission area NEA may be minimized because the sub-pixels SPs included in each of the four different pixels P are disposed close together in the adjacent area AJA, and the users' visibility of the sub-pixels where the dark point occurs to the users SPs may be minimized due to the close distance between the sub-pixels SPs when driving the visual rendering. Accordingly, the transparent display apparatus 100 according to one aspect of the present disclosure may provide a high-quality image to a user even when it includes sub-pixels SPs where dark points occur.

On the other hand, although the red sub-pixel was described above as an example of a sub-pixel where the dark point occurs, when the green sub-pixel is the sub-pixel where the dark point occurs, a green sub-pixel included in each of two or more other pixels adjacent to the sub-pixel where the dark point occurs may emit light by the visual rendering driving method as a shared sub-pixel. Similarly, when the blue sub-pixel is the sub-pixel where the dark point occurs, a blue sub-pixel included in each of the other two or more pixels adjacent to the sub-pixel where the dark point occurs may emit light by the visual rendering driving method as a shared sub-pixel. Further, when the white sub-pixel is the sub-pixel where the dark point occurs, a white sub-pixel included in each of the other two or more pixels adjacent to the sub-pixel where the dark point occurs may emit light by the visual rendering driving method as a shared sub-pixel.

As a result, the transparent display apparatus 100 according to one aspect of the present disclosure may be configured such that at least two or more shared sub-pixels adjacent to the sub-pixel where the dark point occurs emit light, thereby minimizing the visibility of the sub-pixel where the dark point occurs, and improving the service life of the shared sub-pixel compared to the case where only one sub-pixel emits.

On the other hand, in the transparent display apparatus 100 according to one aspect of the present disclosure, the arrangement structure of the first red sub-pixel SP1-1, the first green sub-pixel SP1-2, the first blue sub-pixel SP1-3, and the first white sub-pixel SP1-4 included in the first pixel P1 is described as an example, and is not necessarily limited thereto. The arrangement structure of the first red sub-pixel SP1-1, the first green sub-pixel SP1-2, the first blue sub-pixel SP1-3, and the first white sub-pixel SP1-4 may be variously changed according to the design, provided that the shape of the windmill is maintained. For example, the first red sub-pixel SP1-1 and the first white sub-pixel SP1-4 may be disposed in a row in the first direction D1, and the first green sub-pixel SP1-2 and the first blue sub-pixel SP1-3 may be disposed in a row in the second direction D2.

By disposing a sub-pixel included in one pixel to be adjacent to a sub-pixel included in at least two other pixels, and having the same-colored sub-pixels of the adjacent two pixels emit in place of the sub-pixel where the dark point occurs, the transmissivity of the transmissive portion may be improved compared to a case in which a connecting electrode is disposed in the transmissive portion.

Furthermore, the present disclosure may be configured such that the same-colored sub-pixels of each of two adjacent pixels emit light in place of the sub-pixel where the dark point occurs, thereby minimizing the perceptibility of the sub-pixel where the dark point occurs.

Furthermore, the present disclosure is configured to have at least two sub-pixels (or shared sub-pixels) emitting the same color as the sub-pixel where the dark point occurs emit, thus one sub-pixel (or one shared sub-pixel) may be driven at a lower power than the case that only one sub-pixel of the same color is emitting, thereby reducing overall power consumption.

Furthermore, the present disclosure is configured such that the same-colored sub-pixels of two adjacent pixels emit in place of the sub-pixel where the dark point occurs, thus a reduction in visibility due to diffraction phenomena may be prevented compared to the case where the repair wiring is disposed in the transmissive portion.

A transparent display apparatus according to an aspect of the present disclosure comprises: a substrate; a first pixel disposed on the substrate and having a plurality of first sub-pixels and a plurality of transmissive portions; a second pixel disposed adjacent to the first pixel and having a plurality of second sub-pixels and a plurality of transmissive portions, respectively; and a third pixel disposed adjacent to the first pixel and the second pixel and having a plurality of third sub-pixels and a plurality of transmissive portions, wherein one first sub-pixel of the plurality of first sub-pixels, one second sub-pixel of the plurality of second sub-pixels and one third sub-pixel of the plurality of third sub-pixels are disposed adjacent to each other.

In one or more embodiments, the one first sub-pixel, the one second sub-pixel and the one third sub-pixel emit different colors of light from each other.

In one or more embodiments, the plurality of first sub-pixels comprise: a first red sub-pixel disposed in a first direction; a first green sub-pixel disposed adjacent to the first red sub-pixel and disposed in the first direction; a first blue sub-pixel disposed partially adjacent to each of one side of the first red sub-pixel and one side of the first green sub-pixel, and disposed in a second direction; and a first white sub-pixel disposed partially adjacent to each of another side of the first red sub-pixel and another side of the first green sub-pixel, and disposed in the second direction.

In one or more embodiments, one end of each sub-pixel of the plurality of first sub-pixels, the plurality of second sub-pixels and the plurality of third sub-pixels is provided in a protruding shape, and wherein the other end of each sub-pixel of the plurality of first sub-pixels, the plurality of second sub-pixels and the plurality of third sub-pixels is provided in a shape different from the one end.

In one or more embodiments, the one end is a portion that is adjacent to a sub-pixel of another pixel, and the other end is a portion that is adjacent to another sub-pixel of the same pixel.

In one or more embodiments, the transparent display apparatus further comprises a center area where the first red sub-pixel, the first blue sub-pixel, the first green sub-pixel, and the first white sub-pixel are disposed adjacent to each other.

In one or more embodiments, the plurality of transmissive portion of the first pixel comprise: a first transmissive portion disposed between the first red sub-pixel and the first blue sub pixel; a second transmissive portion disposed between the first blue sub-pixel and the first green sub-pixel; a third transmissive portion disposed between the first green sub-pixel and the first white sub-pixel; and a fourth transmissive portion disposed between the first white sub-pixel and the first red sub-pixel, wherein each of the first transmissive portion, the second transmissive portion, the third transmissive portion, and the fourth transmissive portion has a triangular shape.

In one or more embodiments, the first transmissive portion has a shape symmetrical to the third transmissive portion with respect to the center area, wherein the second transmissive portion has a shape symmetrical to the fourth transmissive portion with respect to the center area.

In one or more embodiments, the transparent display apparatus further comprises a pixel power line for applying a pixel driving voltage to each of the plurality of the first sub-pixels, wherein the pixel power line partially overlaps the center area and overlaps each of the plurality of first sub-pixels.

In one or more embodiments, the pixel power line is disposed to extend in the center area in a predetermined direction and to extend into each of the first red sub-pixel, the first green sub-pixel, the first blue sub-pixel, and the first white sub-pixel, so that the pixel power line is disposed in an X shape in the first pixel.

In one or more embodiments, the transparent display apparatus further comprises: a common power line for applying a common voltage to each of the plurality of the first sub-pixels, wherein the common power line is disposed to partially overlap the first green sub-pixel and the first white sub-pixel.

In one or more embodiments, the transparent display apparatus further comprises: a reference line for applying a reference voltage to each of the plurality of the first sub-pixels, wherein the reference line is disposed to partially overlap the first red sub-pixel and the first blue sub-pixel.

In one or more embodiments, the transparent display apparatus further comprises: a gate line for supplying a gate signal to each of the plurality of the first sub-pixels, wherein the gate line is disposed to partially overlap the first blue sub-pixel, is disposed in a circular or square shape in the center area, and is disposed to partially overlap the first green sub-pixel.

In one or more embodiments, the plurality of second sub-pixels comprise: a second red sub-pixel disposed in the first direction; a second green sub-pixel disposed adjacent to the second red sub-pixel and disposed in the first direction; a second blue sub-pixel disposed partially adjacent to each of one side of the second red sub-pixel and one side of the second green sub-pixel, and disposed in the second direction; and a second white sub-pixel disposed partially adjacent to each of another side of the second red sub-pixel and the other side of the second green sub-pixel, and disposed in the second direction, wherein the first green sub-pixel is disposed adjacent to the second blue sub-pixel, and wherein the first white sub-pixel is disposed adjacent to the second red sub-pixel.

In one or more embodiments, the plurality of third sub-pixels comprise: a third red sub-pixel disposed in the first direction; a third green sub-pixel disposed adjacent to the third red sub-pixel and disposed in the first direction; a third blue sub-pixel disposed partially adjacent to each of one side of the third red sub-pixel and one side of the third green sub-pixel, and disposed in the second direction; and a third white sub-pixel disposed partially adjacent to each of another side of the third red sub-pixel and another side of the third green sub-pixel, and disposed in the second direction, wherein the first green sub-pixel is disposed adjacent to the third white sub-pixel, and wherein the first blue sub-pixel is disposed adjacent to the third red sub-pixel.

In one or more embodiments, when the first red sub-pixel is a sub-pixel where a dark point occurs, the second red sub-pixel and the third red sub-pixel emit light in place of the first red sub-pixel.

In one or more embodiments, a data value of the first red sub-pixel is divided and the divided data values are respectively added to a data value of each of the second red sub-pixel and the third red sub-pixel.

In one or more embodiments, when the first red sub-pixel is the sub-pixel where the dark point occurs, the second red sub-pixel and the third red sub-pixel are shared sub-pixels, wherein the final data value of each of the shared sub-pixels is a sum of the data value of the sub-pixel where the dark point occurs and the data value of each of the N shared sub-pixels (N being an integer greater than 1), divided by N.

In one or more embodiments, the transparent display apparatus further comprises a first data line for driving the first red sub-pixel, wherein the first data line is disposed to partially overlap the first red sub-pixel and the first blue sub-pixel.

In one or more embodiments, the transparent display apparatus further comprises a second data line for driving the first blue sub-pixel, wherein the second data line is disposed to partially overlap the first red sub-pixel and the first blue sub-pixel and is spaced apart from the first data line.

In one or more embodiments, the transparent display apparatus further comprises a third data line for driving the first white sub-pixel, wherein the third data line is disposed to partially overlap the first white sub-pixel and the first green sub-pixel.

In one or more embodiments, the transparent display apparatus further comprises a fourth data line for driving the first green sub-pixel, wherein the fourth data line is disposed to partially overlap the first white sub-pixel and the first green sub-pixel and is spaced apart from the third data line.

In one or more embodiments, the transparent display apparatus further comprises a fourth pixel disposed adjacent to the first pixel and having a plurality of fourth sub-pixels and a plurality of transmissive portion, wherein the one first sub-pixel of the plurality of first sub-pixels, the one second sub-pixel of the plurality of second sub-pixels, the one third sub-pixel of the plurality of third sub-pixels, and one fourth sub-pixel of the plurality of fourth sub-pixels are disposed adjacent to each other.

In one or more embodiments, the plurality of the fourth sub-pixels comprise: a fourth red sub-pixel disposed in the first direction; a fourth green sub-pixel disposed adjacent to the fourth red sub-pixel and disposed in the first direction; a fourth blue sub-pixel disposed partially adjacent to each of one side of the fourth red sub-pixel and one side of the fourth green sub-pixel, and disposed in the second direction; and a fourth white sub-pixel disposed partially adjacent to each of another side of the fourth red sub-pixel and another side of the fourth green sub-pixel, and disposed in the second direction, wherein the first green sub-pixel is adjacent to the fourth red sub-pixel.

In one or more embodiments, when the first red sub-pixel is a sub-pixel where a dark point occurs, the second red sub-pixel, the third red sub-pixel, and the fourth red sub-pixel emit light in place of the first red sub-pixel.

In one or more embodiments, a data value of the first red sub-pixel is divided and the divided data values are respectively added to a data value of each of the second red sub-pixel, the third red sub-pixel and the fourth red sub-pixel.

In one or more embodiments, the transparent display apparatus further comprises: an adjacent area where the first green sub-pixel, the second blue sub-pixel, the third white sub-pixel and the fourth red sub-pixel are adjacent to each other; and a center area where the first red sub-pixel, the first blue sub-pixel, the first green sub-pixel, and the first white sub-pixel are adjacent to each other, wherein the adjacent area and the center area are alternatively disposed in the first direction or the second direction.

A transparent display apparatus according to another aspect of the present disclosure comprises: a substrate; a plurality of pixels disposed on the substrate, each of the plurality pixels including a plurality of sub-pixels and a plurality of transmissive portions; and a wiring for driving the plurality of sub-pixels, wherein the plurality of sub-pixels includes two sub-pixels disposed in a first direction and two sub-pixels disposed in a second direction, so that the plurality of sub-pixels is disposed in an X shape in each pixel, wherein the transmissive portions are disposed between every two sub-pixels of the plurality of sub-pixels, and wherein the wiring partially overlaps the plurality of sub-pixels without overlapping the transmissive portions.

In one or more embodiments, each of the plurality of transmissive portions has a triangular shape.

In one or more embodiments, one end of each of the plurality of sub-pixels is provided in a protruding shape, wherein the other end of each of the plurality of sub-pixels is provided in a shape different from the one end.

In one or more embodiments, the one end is a portion that is adjacent to a sub-pixel of another pixel, and the other end is a portion that is adjacent to another sub-pixel of the same pixel.

It will be apparent to those skilled in the art that various modifications and variations can be made in the transparent display apparatus of the present disclosure without departing from the scope of the aspects of the present disclosure. Thus, it is intended that the present disclosure covers the modifications and variations of the aspects provided they come within the scope of the appended claims.

## Claims

1. A transparent display apparatus (100) comprising:
a substrate (110);
a first pixel (P1) disposed on the substrate (110) and having a plurality of first sub-pixels (SP1) and a plurality of transmissive portions (TA);
a second pixel (P2) disposed adjacent to the first pixel (P1) and having a plurality of second sub-pixels (SP2) and a plurality of transmissive portions (TA), respectively; and
a third pixel (P3) disposed adjacent to the first pixel (P1) and the second pixel (P2) and having a plurality of third sub-pixels (SP3) and a plurality of transmissive portions (TA),
wherein one first sub-pixel (SP1) of the plurality of first sub-pixels (SP1), one second sub-pixel (SP2) of the plurality of second sub-pixels (SP2) and one third sub-pixel (SP3) of the plurality of third sub-pixels (SP3) are disposed adjacent to each other.

2. The transparent display apparatus (100) of claim 1, wherein the one first sub-pixel (SP1), the one second sub-pixel (SP2) and the one third sub-pixel (SP3) emit different colors of light from each other.

3. The transparent display apparatus (100) of claim 1 or 2, wherein one end of each sub-pixel of the plurality of first sub-pixels (SP1), the plurality of second sub-pixels (SP2) and the plurality of third sub-pixels (SP3) is provided in a protruding shape, and
wherein the other end of each sub-pixel of the plurality of first sub-pixels (SP1), the plurality of second sub-pixels (SP2) and the plurality of third sub-pixels (SP3) is provided in a shape different from the one end,
wherein, preferably, the one end is a portion that is adjacent to a sub-pixel of another pixel, and the other end is a portion that is adjacent to another sub-pixel of the same pixel.

4. The transparent display apparatus (100) of any of claims 1 to 3, wherein the plurality of first sub-pixels (SP1) comprise:
a first red sub-pixel (SP1-1) disposed in a first direction (D1);
a first green sub-pixel (SP1-2) disposed adjacent to the first red sub-pixel (SP1-1) and disposed in the first direction (D1);
a first blue sub-pixel (SP1-3) disposed partially adjacent to each of one side of the first red sub-pixel (SP1-1) and one side of the first green sub-pixel (SP1-2), and disposed in a second direction (D2); and
a first white sub-pixel (SP1-4) disposed partially adjacent to each of another side of the first red sub-pixel (SP1-1) and another side of the first green sub-pixel (SP1-2), and disposed in the second direction (D2).

5. The transparent display apparatus (100) of claim 4, further comprising a center area (CTA) where the first red sub-pixel (SP1-1), the first blue sub-pixel (SP1-3), the first green sub-pixel (SP1-2), and the first white sub-pixel (SP1-4) are disposed adjacent to each other.

6. The transparent display apparatus (100) of claim 5, wherein the plurality of transmissive portions (TA) of the first pixel (P1) comprise:
a first transmissive portion (TA1) disposed between the first red sub-pixel (SP1-1) and the first blue sub pixel (SP1-3);
a second transmissive portion (TA2) disposed between the first blue sub-pixel (SP1-3) and the first green sub-pixel (SP1-2);
a third transmissive portion (TA3) disposed between the first green sub-pixel (SP1-2) and the first white sub-pixel (SP1-4); and
a fourth transmissive portion (TA4) disposed between the first white sub-pixel (SP1-4) and the first red sub-pixel (SP1-1),
wherein each of the first transmissive portion (TA1), the second transmissive portion (TA2), the third transmissive portion (TA3), and the fourth transmissive portion (TA4) has a triangular shape,
wherein preferably:
the first transmissive portion (TA1) has a shape symmetrical to the third transmissive portion (TA3) with respect to the center area (CTA), and
the second transmissive portion (TA2) has a shape symmetrical to the fourth transmissive portion (TA4) with respect to the center area (CTA).

7. The transparent display apparatus (100) of claim 5 or 6, further comprising a pixel power line (EVDD) for applying a pixel driving voltage to each of the plurality of the first sub-pixels (SP1),
wherein the pixel power line (EVDD) partially overlaps the center area (CTA) and overlaps each of the plurality of first sub-pixels (SP1),
wherein, preferably, the pixel power line (EVDD) is disposed to extend in the center area (CAT) in a predetermined direction and to extend into each of the first red sub-pixel (SP1-1), the first green sub-pixel (SP1-2), the first blue sub-pixel (SP1-3), and the first white sub-pixel (SP1-4), so that the pixel power line (EVDD) is disposed in an X shape in the first pixel (P1).

8. The transparent display apparatus (100) of any of claims 5 to 7, further comprising:
a common power line (EVSS) for applying a common voltage to each of the plurality of the first sub-pixels (SP1),
wherein the common power line (EVSS) is disposed to partially overlap the first green sub-pixel (SP1-2) and the first white sub-pixel (SP1-4); and/or
further comprising:
a reference line (RL) for applying a reference voltage to each of the plurality of the first sub-pixels (SP1),
wherein the reference line (RL) is disposed to partially overlap the first red sub-pixel (SP1-1) and the first blue sub-pixel (SP1-3); and/or
further comprising:
a gate line (GL) for supplying a gate signal to each of the plurality of the first sub-pixels (SP1),
wherein the gate line (GL) is disposed to partially overlap the first blue sub-pixel (SP1-3), is disposed in a circular or square shape in the center area (CTA), and is disposed to partially overlap the first green sub-pixel (SP1-2).

9. The transparent display apparatus (100) of any of claims 4 to 8, wherein the plurality of second sub-pixels (SP2) comprise:
a second red sub-pixel (SP2-1) disposed in the first direction (D1);
a second green sub-pixel (SP2-2) disposed adjacent to the second red sub-pixel (SP2-1) and disposed in the first direction (D1);
a second blue sub-pixel (SP2-3) disposed partially adjacent to each of one side of the second red sub-pixel (SP2-1) and one side of the second green sub-pixel (SP2-2), and disposed in the second direction (D2); and
a second white sub-pixel (SP2-4) disposed partially adjacent to each of another side of the second red sub-pixel (SP2-1) and the other side of the second green sub-pixel (SP2-2), and disposed in the second direction (D2),
wherein the first green sub-pixel (SP1-2) is disposed adjacent to the second blue sub-pixel (SP2-3), and
wherein the first white sub-pixel (SP1-4) is disposed adjacent to the second red sub-pixel (SP2-1).

10. The transparent display apparatus (100) of claim 9, wherein the plurality of third sub-pixels (SP3) comprise:
a third red sub-pixel (SP3-1) disposed in the first direction (D1);
a third green sub-pixel (SP3-2) disposed adjacent to the third red sub-pixel (SP3-1) and disposed in the first direction (D1);
a third blue sub-pixel (SP3-3) disposed partially adjacent to each of one side of the third red sub-pixel (SP3-1) and one side of the third green sub-pixel (SP3-2), and disposed in the second direction (D2); and
a third white sub-pixel (SP3-4) disposed partially adjacent to each of another side of the third red sub-pixel (SP3-1) and another side of the third green sub-pixel (SP3-2), and disposed in the second direction (D2),
wherein the first green sub-pixel (SP1-2) is disposed adjacent to the third white sub-pixel (SP3-4), and
wherein the first blue sub-pixel (SP1-3) is disposed adjacent to the third red sub-pixel (SP3-1).

11. The transparent display apparatus (100) of claim 10, further configured such that, when the first red sub-pixel (SP1-1) is a sub-pixel where a dark point occurs, the second red sub-pixel (SP2-1) and the third red sub-pixel (SP3-1) emit light in place of the first red sub-pixel (SP1-1).

12. The transparent display apparatus (100) of claim 11, further configured such that a data value of the first red sub-pixel (SP1-1) is divided and the divided data values are respectively added to a data value of each of the second red sub-pixel (SP2-1) and the third red sub-pixel (SP3-1).

13. The transparent display apparatus (100) of claim 11 or 12, further configured such that, when the first red sub-pixel (SP1-1) is the sub-pixel where the dark point occurs, the second red sub-pixel (SP2-1) and the third red sub-pixel (SP3-1) are shared sub-pixels, and
wherein the final data value of each of the shared sub-pixels is a sum of the data value of the sub-pixel where the dark point occurs and the data value of each of the N shared sub-pixels, divided by N, wherein N is an integer greater than 1.

14. The transparent display apparatus (100) of any of claims 4 to 13, further comprising a first data line (DL1) for driving the first red sub-pixel (SP1-1),
wherein the first data line (DL1) is disposed to partially overlap the first red sub-pixel (SP1-1) and the first blue sub-pixel (SP1-3);
and, preferably, further comprising a second data line (DL2) for driving the first blue sub-pixel (SP1-3),
wherein the second data line (DL2) is disposed to partially overlap the first red sub-pixel (SP1-1) and the first blue sub-pixel (SP1-3) and is spaced apart from the first data line (DL1).

15. The transparent display apparatus (100) of any of claims 4 to 14, further comprising a third data line (DL3) for driving the first white sub-pixel (SP1-4),
wherein the third data line (DL3) is disposed to partially overlap the first white sub-pixel (SP1-4) and the first green sub-pixel (SP1-2);
and, preferably, further comprising a fourth data line (DL4) for driving the first green sub-pixel (SP1-2),
wherein the fourth data line (DL4) is disposed to partially overlap the first white sub-pixel (SP1-4) and the first green sub-pixel (SP1-2) and is spaced apart from the third data line (DL3).

16. The transparent display apparatus (100) of claim 10, or any of claims 10 to 15 referring directly or indirectly back to claim 10, further comprising a fourth pixel (P4) disposed adjacent to the first pixel (P1) and having a plurality of fourth sub-pixels (SP4) and a plurality of transmissive portions (TA),
wherein the one first sub-pixel of the plurality of first sub-pixels (SP1), the one second sub-pixel of the plurality of second sub-pixels (SP2), the one third sub-pixel of the plurality of third sub-pixels (SP3), and one fourth sub-pixel of the plurality of fourth sub-pixels (SP4) are disposed adjacent to each other.

17. The transparent display apparatus (100) of claim 16, wherein the plurality of the fourth sub-pixels (SP4) comprise:
a fourth red sub-pixel (SP4-1) disposed in the first direction (D1);
a fourth green sub-pixel (SP4-2) disposed adjacent to the fourth red sub-pixel (SP4-1) and disposed in the first direction (D1);
a fourth blue sub-pixel (SP4-3) disposed partially adjacent to each of one side of the fourth red sub-pixel (SP4-1) and one side of the fourth green sub-pixel (SP4-2), and disposed in the second direction (D2); and
a fourth white sub-pixel (SP4-4) disposed partially adjacent to each of another side of the fourth red sub-pixel (SP4-1) and another side of the fourth green sub-pixel (SP4-2), and disposed in the second direction (D2),
wherein the first green sub-pixel (SP1-2) is adjacent to the fourth red sub-pixel (SP4-1).

18. The transparent display apparatus (100) of claim 17, further configured such that, when the first red sub-pixel (SP1-1) is a sub-pixel where a dark point occurs, the second red sub-pixel (SP2-1), the third red sub-pixel (SP3-1), and the fourth red sub-pixel (SP4-1) emit light in place of the first red sub-pixel (SP1-1);
and, preferably, further configured such that a data value of the first red sub-pixel (SP1-1) is divided and the divided data values are respectively added to a data value of each of the second red sub-pixel (SP2-1), the third red sub-pixel (SP3-1) and the fourth red sub-pixel (SP4-1).

19. The transparent display apparatus (100) of claim 17 or 18, further comprising:
an adjacent area (AJA) where the first green sub-pixel (SP1-2), the second blue sub-pixel (SP2-3), the third white sub-pixel (SP3-4) and the fourth red sub-pixel (SP4-1) are adj acent to each other; and
a center area (CTA) where the first red sub-pixel (SP1-1), the first blue sub-pixel (SP1-3), the first green sub-pixel (SP1-2), and the first white sub-pixel (SP1-4) are adjacent to each other,
wherein the adjacent area (AJA) and the center area (CTA) are alternatively disposed in the first direction (D1) or the second direction (D2).
